Europäisches Patentamt

European Patent Office

Office européen des brevets

(19)

(11) EP 1 569 284 A1

(12) **EUROPEAN PATENT APPLICATION**
published in accordance with Art. 158(3) EPC

(43) Date of publication:
**31.08.2005 Bulletin 2005/35**

(21) Application number: **03777267.0**

(22) Date of filing: **04.12.2003**

(51) Int Cl.7: **H01L 37/02**, G01J 1/02, H01B 3/00, H01B 3/12

(86) International application number:
**PCT/JP2003/015564**

(87) International publication number:
**WO 2004/051760 (17.06.2004 Gazette 2004/25)**

(84) Designated Contracting States:
**AT BE BG CH CY CZ DE DK EE ES FI FR GB GR HU IE IT LI LU MC NL PT RO SE SI SK TR**

(30) Priority: 05.12.2002 JP 2002354083
12.02.2003 JP 2003033552
28.07.2003 JP 2003280941

(71) Applicant: **MATSUSHITA ELECTRIC INDUSTRIAL CO., LTD.**
**Osaka 571-8501 (JP)**

(72) Inventors:
• **TOMOZAWA, Atsushi**
**Osaka-shi, Osaka 559-0007 (JP)**
• **FUJII, Satoru**
**Takatsuki-shi, Osaka 569-1036 (JP)**
• **FUJII, Eiji**
**Hirakata-shi, Osaka 573-0001 (JP)**
• **TORII, Hideo**
**Higashiosaka-shi, Osaka 578-0976 (JP)**
• **TAKAYAMA, Ryoichi**
**Suita-shi, Osaka 564-0081 (JP)**

(74) Representative: **Grünecker, Kinkeldey, Stockmair & Schwanhäusser Anwaltssozietät Maximilianstrasse 58 80538 München (DE)**

(54) **PYROELECTRIC DEVICE, METHOD FOR MANUFACTURING SAME AND INFRARED SENSOR**

(57) A first electrode layer made of a noble metal containing at least one additive selected from the group consisting of Ti, Co, Ni, Mg, Fe, Ca, Sr, Mn, Ba and Al and oxides thereof, a pyroelectric layer having a thickness of 0.5 to 5 $\mu$m and having a perovskite crystalline structure whose chemical composition is represented as $(Pb_{(1-y)}La_y)Ti_{(1-y/4)}O_3$ ($0<y\leq0.2$) or $(Pb_{(1-y)}La_y)(Zr_x Ti_{(1-x)})_{(1-y/4)}O_3$ ($0<x\leq0.2$ or $0.55\leq x<0.8$, $0<y\leq0.2$), and a second electrode layer are formed in this order on a substrate, to obtain a pyroelectric device.

FIG. 1

## Description

TECHNICAL FIELD

The present invention relates to a pyroelectric device and a method for manufacturing the same, and an infrared radiation sensor.

BACKGROUND ART

A pyroelectric device includes a pair of electrodes provided on a substrate, and a polarized pyroelectric thin film provided between the pair of electrodes. When the pyroelectric device is irradiated with infrared rays, the surface temperature thereof changes and the degree of polarization changes accordingly, whereby an electric charge appears on the surface of the pyroelectric device, and the temperature change can be measured by detecting the electric charge. Thus, a pyroelectric device can be used as an infrared detector.

For conventional pyroelectric devices, techniques have been developed to improve the crystallinity and the orientation of the pyroelectric thin film so that the pyroelectric devices can be used as small-sized, high-performance infrared detectors (see, for example, Japanese Laid-Open Patent Publication Nos. 7-300397, 7-211135, 11-220185 and 7-307496).

Referring to the cross-sectional view of FIG. **4,** the pyroelectric device described in Japanese Laid-Open Patent Publication No. 7-300397 includes a first electrode layer **11** provided on a substrate **10,** an intermediate layer **12** made of a (100)-oriented oxide thin film having a salt (NaCl)-type crystalline structure such as NiO, CoO or MgO provided on the electrode layer, a (001)-oriented pyroelectric thin film **13** provided on the intermediate layer, and a second electrode layer **14** provided on the pyroelectric thin film.

Japanese Laid-Open Patent Publication No. 7-211135 describes a technique of providing Pt as a lower electrode on an MgO single-crystal plate, forming a (001)-oriented ferroelectric (pyroelectric) thin film thereon by a sputtering method and further providing an Ni-Cr electrode thereon to obtain a sensor element.

Japanese Laid-Open Patent Publication No. 11-220185 describes a technique of coating Pt to obtain an electrode on a substrate, applying thereon a precursor of an organic metal compound, which is a PZT ferroelectric material, and thermally decomposing the precursor to obtain a ferroelectric thin film.

Japanese Laid-Open Patent Publication No. 7-307496 describes a technique of forming a (111)-oriented Pt electrode on a silicon substrate, and forming a PLZT pyroelectric thin film thereon so that it is oriented along the (111) plane.

However, with the structure of the pyroelectric thin film of Japanese Laid-Open Patent Publication No. 7-300397, a step of forming the intermediate layer is necessary, and the crystallinity and the orientation of the intermediate layer influence those of the pyroelectric thin film. Therefore, when mass-produced, the pyroelectric characteristics vary significantly and the peeling phenomenon occurs due to a decrease in the adhesion of the film, thus decreasing the yield in mass production.

With the structure of the pyroelectric thin film of Japanese Laid-Open Patent Publication No. 7-211135, an expensive MgO single-crystal plate is necessary for obtaining the (001)-oriented ferroelectric (pyroelectric) thin film, thereby posing a cost problem.

With the method described in Japanese Laid-Open Patent Publication No. 11-220185, the ferroelectric thin film is formed by a sol-gel method, whereby a crack is likely to occur and the film is likely to peel off due to volumetric changes through heating steps such as the thermal decomposition step. This decreases the yield in mass production.

With the structure of the pyroelectric thin film of Japanese Laid-Open Patent Publication No. 7-307496, the crystallinity of the electrode has a substantial influence on the pyroelectric thin film, thus imposing limitations on the substrate type, the substrate orientation, the electrode type, the electrode thickness, etc. Moreover, the pyroelectric material formed thereon is not 100% (111)-oriented. Therefore, when mass-produced, the pyroelectric characteristics vary significantly, thus decreasing the yield.

The present invention has been made to solve these problems in the prior art, and has an object to provide a pyroelectric device whose pyroelectric thin film has desirable crystallinity and orientation with a small pyroelectric characteristics variation, and which can be manufactured at a low cost. Another object of the present invention is to provide a method for manufacturing a pyroelectric device with a smaller number of production steps and with a desirable mass-production yield. Yet another object of the present invention is to provide an infrared radiation sensor that can be manufactured at a low cost with a small characteristics variation.

DISCLOSURE OF THE INVENTION

A pyroelectric device of the present invention includes: a first electrode layer; a pyroelectric layer provided on the first electrode layer; and a second electrode layer provided on the pyroelectric layer, wherein: the first electrode layer includes a noble metal containing at least one additive selected from the group consisting of Ti, Co, Ni, Mg, Fe, Ca, Sr, Mn, Ba and Al and oxides thereof; and the pyroelectric layer includes a pyroelectric material having a perovskite crystalline structure whose composition is represented as:

$$(Pb_{(1-y)}La_y)Ti_{(1-y/4)}O_3$$

$$(\text{where } 0<y\leq0.2)$$

or

$$(Pb_{(1-y)}La_y)(Zr_xTi_{(1-x)})_{(1-y/4)}O_3$$

$$(\text{where } 0<x\leq0.2 \text{ or } 0.55\leq x<0.8 \text{ and } 0<y\leq0.2).$$

It is preferred that the pyroelectric layer further includes AOn (A is Mg or Mn, wherein n=1 if A is Mg, and n=2 if A is Mn) at a composition represented as:

$$(1-z)\{(Pb_{(1-y)}La_y)Ti_{(1-y/4)}O_3\}+zAOn$$

$$(\text{where } 0<y\leq0.2 \text{ and } 0<z\leq0.1)$$

or

$$(1-z)\{(Pb_{(1-y)}La_y)(Zr_xTi_{(1-x)})_{(1-y/4)}O_3\}+zAOn$$

$$(\text{where } 0<x\leq0.2 \text{ or } 0.55\leq x<0.8,\ 0<y\leq0.2 \text{ and } 0<z\leq0.1).$$

It is preferred that the pyroelectric layer has a thickness of 0.5 $\mu$m to 5 $\mu$m.
It is preferred that the first electrode layer is provided on a substrate; and the substrate has an average thermal expansion coefficient 110% to 300% of that of the pyroelectric layer.
It is preferred that the first electrode layer is provided on a substrate; and the substrate has an average thermal expansion coefficient 20% to 100% of that of the pyroelectric layer. It is more preferred that the pyroelectric layer includes a pyroelectric material having a perovskite crystalline structure preferentially oriented along the rhombohedral (100) plane and having a composition represented as:

$$(Pb_{(1-y)}La_y)(Zr_xTi_{(1-x)})_{(1-y/4)}O_3$$

$$(\text{where } 0.55\leq x<0.8 \text{ and } 0<y\leq0.2).$$

Moreover, it is more preferred that the pyroelectric layer further includes AOn (A is Mg or Mn, wherein n=1 if A is Mg, and n=2 if A is Mn) at a composition represented as:

$$(1-z)\{(Pb_{(1-y)}La_y)(Zr_xTi_{(1-x)})_{(1-y/4)}O_3\}+zAOn$$

$$(\text{where } 0.55\leq x<0.8,\ 0<y\leq0.2 \text{ and } 0<z\leq0.1).$$

In addition, it is preferred that the first electrode layer includes at least one noble metal selected from the group consisting of Pt, Ir, Pd and Ru and at least one additive selected from the group consisting of Ti, Co, Ni, Mg, Fe, Ca, Sr, Mn, Ba and Al and oxides thereof.

Moreover, it is preferred that the content of the at least one additive selected from the group consisting of Ti, Co, Ni, Mg, Fe, Ca, Sr, Mn, Ba and Al and oxides thereof in the first electrode layer is greater than 0 and less than or equal to 20 mol% with respect to that of the noble metal.

A method for manufacturing a pyroelectric device of the present invention includes: a first step of forming a first electrode layer made of a noble metal containing at least one additive selected from the group consisting of Ti, Co, Ni, Mg, Fe, Ca, Sr, Mn, Ba and Al and oxides thereof on a substrate; a second step of forming, on the first electrode layer, a pyroelectric layer having a thickness of 0.5 μm to 5 μm and including a pyroelectric material having a perovskite crystalline structure whose composition is represented as:

$$(Pb_{(1-y)}La_y)Ti_{(1-y/4)}O_3$$

(where $0 < y \leq 0.2$)

or

$$(Pb_{(1-y)}La_y)(Zr_xTi_{(1-x)})_{(1-y/4)}O_3$$

(where $0 < x \leq 0.2$ or $0.55 \leq x < 0.8$ and $0 < y \leq 0.2$); and

a third step of forming a second electrode layer on the pyroelectric layer.

It is preferred that the pyroelectric layer further includes AOn (A is Mg or Mn, wherein n=1 if A is Mg, and n=2 if A is Mn) at a composition represented as:

$$(1-z)\{(Pb_{(1-y)}La_y)Ti_{(1-y/4)}O_3\}+zAOn$$

(where $0 < y \leq 0.2$ and $0 < z \leq 0.1$)

or

$$(1-z)\{(Pb_{(1-y)}La_y)(Zr_xTi_{(1-x)})_{(1-y/4)}O_3\}+zAOn$$

(where $0 < x \leq 0.2$ or $0.55 \leq x < 0.8$, $0 < y \leq 0.2$ and $0 < z \leq 0.1$).

It is preferred that the second step is performed by a sputtering method.

An infrared radiation sensor of the present invention includes: a pyroelectric device; and an output terminal for outputting an electric signal from the pyroelectric device, wherein: the pyroelectric device includes a first electrode layer, a pyroelectric layer provided on the first electrode layer, and a second electrode layer provided on the pyroelectric layer; the first electrode layer includes a noble metal containing at least one additive selected from the group consisting of Ti, Co, Ni, Mg, Fe, Ca, Sr, Mn, Ba and Al and oxides thereof; and the pyroelectric layer has a thickness of 0.5 μm to 5 μm and includes a pyroelectric material having a perovskite crystalline structure whose composition is represented as:

$$(Pb_{(1-y)}La_y)Ti_{(1-y/4)}O_3$$

(where $0 < y \leq 0.2$)

or

$$(Pb_{(1-y)}La_y)(Zr_xTi_{(1-x)})_{(1-y/4)}O_3$$

(where $0<x\leq0.2$ or $0.55\leq x<0.8$ and $0<y\leq0.2$).

It is preferred that the pyroelectric layer further includes AOn (A is Mg or Mn, wherein n=1 if A is Mg, and n=2 if A is Mn) at a composition represented as:

$$(1-z)\{(Pb_{(1-y)}La_y)Ti_{(1-y/4)}O_3\}+zAOn$$

(where $0<y\leq0.2$ and $0<z\leq0.1$)

or

$$(1-z)\{(Pb_{(1-y)}La_y)(Zr_xTi_{(1-x)})_{(1-y/4)}O_3\}+zAOn$$

(where $0<x\leq0.2$ or $0.55\leq x<0.8$, $0<y\leq0.2$ and $0<z\leq0.1$).

BRIEF DESCRIPTION OF THE DRAWINGS

FIG. **1** is a cross-sectional view of a pyroelectric device according to an embodiment of the present invention.
FIG. **2** is a chart showing a process of manufacturing a pyroelectric device according to an embodiment of the present invention.
FIG. **3** is a cross-sectional view of an infrared radiation sensor according to an embodiment of the present invention.
FIG. **4** is a cross-sectional view of a conventional pyroelectric device.
FIG. **5** is a table showing characteristics of Example 1 and Comparative Examples 1 to 3.
FIG. **6** is a table showing characteristics of Example 2 and Comparative Example 4.
FIG. **7** is a table showing characteristics of Example 3 and Comparative Example 5.
FIG. **8** is a table showing characteristics of Example 4 and Comparative Example 6.
FIG. **9** is a table showing characteristics of Example 5 and Comparative Example 7.
FIG. **10** is a table showing characteristics of Example 6 and Comparative Examples 8 to 10.
FIG. **11** is a table showing characteristics of Example 7 and Comparative Example 11.
FIG. **12** is a table showing characteristics of Example 8 and Comparative Example 12.
FIG. **13** is a table showing characteristics of Example 9 and Comparative Example 13.
FIG. **14** is a table showing characteristics of Example 10 and Comparative Examples 14 to 16.
FIG. **15** is a table showing characteristics of Example 11 and Comparative Example 17.
FIG. **16** is a table showing characteristics of Example 12 and Comparative Example 18.
FIG. **17** is a table showing characteristics of Example 13 and Comparative Example 19.

BEST MODE FOR CARRYING OUT THE INVENTION

Before describing an embodiment of the present invention, the crystallinity and the orientation of a pyroelectric thin film researched by the present inventors will be described.
It is known in the prior art that the pyroelectric characteristics of a pyroelectric device are improved by using a perovskite crystal that is preferentially oriented along the tetragonal (001) plane as the pyroelectric thin film of the pyroelectric device. Conventionally, the crystallinity and the orientation of the pyroelectric thin film are improved by using a substance oriented along the (001) plane for the substrate or the intermediate layer, being a layer under the pyroelectric thin film, as described in Japanese Laid-Open Patent Publication No. 7-300397 or 7-211135, or by using a sol-gel method as described in Japanese Laid-Open Patent Publication No. 11-220185. However, there are some problems as pointed out earlier.

It is also known in the prior art that the pyroelectric characteristics of a pyroelectric device are improved by using a perovskite crystal preferentially oriented along the rhombohedral (111) plane for the pyroelectric thin film of the pyroelectric device since the polarization axis is along the (111) axis. In Japanese Laid-Open Patent Publication No. 7-307496, the crystallinity and the orientation of the pyroelectric thin film are improved by forming a (111)-oriented Pt electrode on a silicon substrate. However, there are some problems as pointed out earlier.

Through various experiments, the present inventors have found that the crystallinity and the orientation of the pyroelectric thin film can be improved by adding at least one additive selected from the group consisting of Ti, Co, Ni, Mg, Fe, Ca, Sr, Mn, Ba and Al (which are base metals) and oxides of these base metals to a lower electrode (first electrode layer) forming the pyroelectric thin film (pyroelectric layer).

The orientation plane of the pyroelectric thin film is dependent on the thermal expansion coefficient of the substrate. Specifically, where the thermal expansion coefficient of the substrate is larger than that of the pyroelectric thin film, a compressive stress acts upon the pyroelectric thin film from the step of forming the pyroelectric thin film until it is cooled to room temperature, whereby the pyroelectric thin film is oriented along the (001) plane perpendicular to the substrate. Where the thermal expansion coefficient of the substrate is smaller than that of the pyroelectric thin film, a tensile stress acts upon the pyroelectric thin film from the step of forming the pyroelectric thin film until it is cooled to room temperature, whereby the pyroelectric thin film is oriented along the (100) plane perpendicular to the substrate.

Therefore, when a substrate having a larger thermal expansion coefficient than that of the pyroelectric thin film, such as a stainless steel, is used, the pyroelectric thin film is oriented along the (001) plane. Then, if a tetragonal perovskite crystal is used, the polarization axis will be perpendicular to the substrate, thereby obtaining a maximum degree of polarization between the upper electrode (second electrode layer) and the lower electrode (first electrode layer) formed on the pyroelectric thin film.

When a substrate having a smaller thermal expansion coefficient than that of the pyroelectric thin film, such as silicon, is used, the pyroelectric thin film is oriented along the (100) plane. Then, if a tetragonal perovskite crystal is used, the polarization axis will be parallel to the substrate, thereby obtaining theoretically no polarization between the upper electrode (second electrode layer) and the lower electrode (first electrode layer) formed on the pyroelectric thin film. If the pyroelectric thin film is made of a rhombohedral perovskite crystal, the polarization axis will be inclined by about 57° with respect to the substrate, thereby obtaining a degree of polarization between the first and second electrode layers. By making the first electrode layer as described above, the pyroelectric layer will be strongly oriented along the (100) plane and will have a desirable crystallinity. Then, even if the polarization axis is inclined, a high degree of polarization is obtained between the first and second electrode layers, thus obtaining desirable pyroelectric characteristics.

An embodiment of the present invention will now be described with reference to the drawings. Note that the present invention is not limited to the following embodiment.

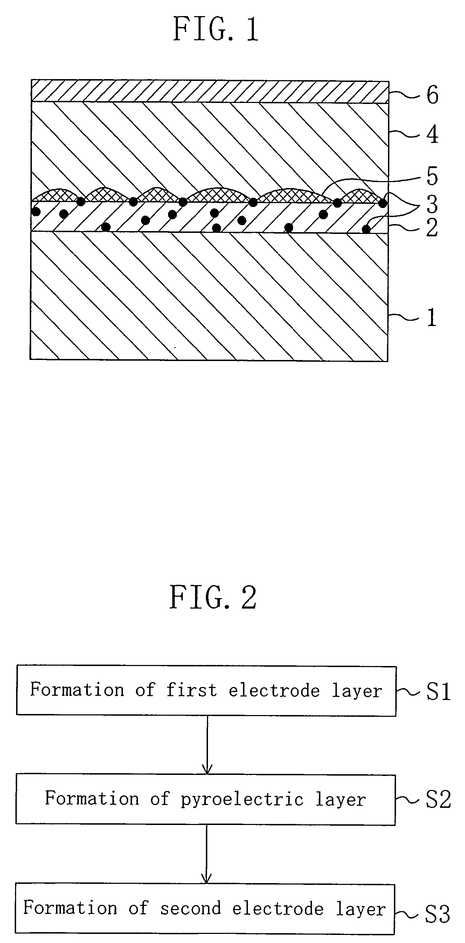

Referring to FIG. **1,** a pyroelectric device according to an embodiment of the present invention includes a first electrode layer **2** provided on a substrate **1.** A pyroelectric layer **4** is provided on the first electrode layer **2,** and a second electrode layer **6** is provided thereon. Thus, in the pyroelectric device of the present embodiment, the first electrode layer **2,** the pyroelectric layer **4** and the second electrode layer **6** are formed in this order on the substrate **1.** The first electrode layer **2** includes at least one additive **3** selected from the group consisting of Ti, Co, Ni, Mg, Fe, Ca, Sr, Mn, Ba and Al and oxides thereof and a noble metal.

The pyroelectric layer **4** is made of a pyroelectric material of a perovskite crystalline structure having a composition represented as:

$$(Pb_{(1-y)}La_y)Ti_{(1-y/4)}O_3$$

$$(\text{where } 0<y\leq0.2)$$

or

$$(Pb_{(1-y)}La_y)(Zr_xTi_{(1-x)})_{(1-y/4)}O_3$$

$$(\text{where } 0<x\leq0.2 \text{ or } 0.55\leq x<0.8 \text{ and } 0<y\leq0.2).$$

Desirable pyroelectric characteristics can be obtained by employing such composition, orientation and crystallinity.

If the pyroelectric material has a composition represented as:

$(Pb_{(1-y)}La_y)Ti_{(1-y/4)}O_3$ (where $0<y\leq0.2$) (hereinafter, a substance represented by this composition formula will be referred to as "PLT")

or

$(Pb_{(1-y)}La_y)(Zr_xTi_{(1-x)})_{(1-y/4)}O_3$ (hereinafter, a substance represented by this composition formula will be referred to as "PLZT") (where $0<x\leq0.2$ and $0<y\leq0.2$),

the pyroelectric material has a perovskite crystalline structure preferentially oriented along the tetragonal (001) plane, whereas if the pyroelectric material has a composition represented as:

$(Pb_{(1-y)}La_y)(Zr_xTi_{(1-x)})_{(1-y/4)}O_3$ (where $0.55\leq x<0.8$ and $0<y\leq0.2$),

the pyroelectric material has a perovskite crystalline structure preferentially oriented along the rhombohedral (100) plane. Note that "being preferentially oriented along the (001) plane", for example, means that the pyroelectric layer **4** is dominantly oriented along the (001) plane in a direction perpendicular to the surface of the first electrode layer **2,** i.e., the (001) plane accounts for a higher proportion than other crystal orientation planes.

Some particles of the additive **3** made of at least one of aluminum (Al) and aluminum oxide ($Al_2O_3$) are exposed on the surface of the first electrode layer **2** of the present embodiment. Where the pyroelectric material is PLT or PLZT whose Zr content is 0 to 20%, when the pyroelectric layer **4** is formed on the first electrode layer **2,** a crystal grows while being preferentially oriented along the tetragonal (001) plane with the exposed particles of the additive **3** being crystal nuclei. A pyroelectric thin film **5,** which is formed on areas of the surface where no particle of the additive **3** is present, is either amorphous or (111)-oriented. As the pyroelectric layer **4** grows, the pyroelectric thin film preferentially oriented along the tetragonal (001) plane becomes dominant, and the pyroelectric thin film **5,** which is either amorphous or (111)-oriented, does not substantially grow in the thickness direction and is covered by the pyroelectric thin film preferentially oriented along the tetragonal (001) plane. Such a phenomenon has been first discovered by the present inventors.

Although this phenomenon has not been accurately elucidated, it is assumed to be a phenomenon as follows.

The additive **3** is exposed at some positions on the surface of the first electrode layer **2.** While the additive **3** is made of at least one of aluminum and aluminum oxide, aluminum is turned into aluminum oxide at the surface of the first electrode layer **2** by the reaction with oxygen in the reaction gas through the high-temperature heat treatment before the formation of the pyroelectric layer **4.** Then, when a pyroelectric material is sputtered onto the first electrode layer **2,** Pb in the pyroelectric material is urged to bind to oxygen atoms of aluminum oxide in the additive **3.** Therefore, the oxygen atoms of aluminum oxide and the Pb atoms are regularly arranged at the surface of the first electrode layer **2** with the aluminum atoms being nuclei. This accounts for the (100) plane of the pyroelectric material. Then, further forming a pyroelectric material thereon gives a pyroelectric thin film with desirable crystallinity that is preferentially oriented along the (001) plane in a direction perpendicular to the surface of the first electrode layer **2.**

Where the pyroelectric material is PLZT whose Zr content is 55 to 80%, when the pyroelectric layer **4** is formed on the first electrode layer **2,** a crystal grows while being preferentially oriented along the rhombohedral (100) plane with the exposed particles of the additive **3** being crystal nuclei. The pyroelectric thin film **5,** which is formed on areas of the surface where no particle of the additive **3** is present, is either amorphous or (110)-oriented. As the pyroelectric layer **4** grows, the pyroelectric thin film preferentially oriented along the rhombohedral (100) plane becomes dominant, and the pyroelectric thin film 5, which is either amorphous or (110)-oriented, does not substantially grow in the thickness direction and is covered by the pyroelectric thin film preferentially oriented along the rhombohedral (100) plane. Such a phenomenon has also been first discovered by the present inventors, and is assumed to occur based on a mechanism as described above.

The content c of the additive **3** with respect to that of the noble metal in the first electrode layer **2** is preferably $0<c\leq20$ mol%. Thus, it is preferred that the content of at least one of aluminum and aluminum oxide is greater than 0 and is less than or equal to 20 mol% with respect to that of the noble metal. The content of the additive **3** being 0 is undesirable because the pyroelectric thin film preferentially oriented along the tetragonal (001) plane or the rhombohedral (100) plane will not be formed. The content of the additive **3** being greater than 20 mol% is also undesirable because the tetragonal (111) plane, the rhombohedral (110) plane, a non-tetragonal, non-rhombohedral crystal phase or an amorphous phase will grow. The reason for this is assumedly as follows. An excessive amount of aluminum oxide is exposed on the surface of the first electrode layer **2,** whereby oxygen atoms bound to aluminum and Pb atoms can no longer be regularly arranged at the surface of the first electrode layer **2.** Then, a (100) plane of the pyroelectric material cannot be formed on the surface of the first electrode layer **2,** whereby the pyroelectric material formed thereon cannot be preferentially oriented along the tetragonal (001) plane or the rhombohedral (100) plane. The lower limit for the content of the additive **3** is more preferably 0.1 mol% or more, and even more preferably 1.0 mol% or more, in terms of the ease of formation of a pyroelectric thin film that is preferentially oriented along the tetragonal (001) plane or the rhombohedral (100) plane. Note that the ratio between the area of the surface of the first electrode layer **2** across which the noble metal is exposed and the area of the surface of the first electrode layer **2** across which the additive **3** is exposed is substantially equal to the ratio between the content of the noble metal and that of the additive **3.**

Moreover, the maximum length of the additive **3** exposed on the surface of the first electrode layer **2** is preferably 0.002 μm or less. The maximum length being greater than 0.002 μm is undesirable in terms of the crystallinity of the pyroelectric thin film. Note that as long as the maximum length is 0.1 nm or more, it is possible to obtain a pyroelectric thin film with desirable crystallinity and orientation.

Moreover, it is preferred that the thickness of the pyroelectric thin film **5,** which is amorphous, (111)-oriented or (110)-oriented, is controlled to be 0.05 μm or less by, for example, controlling the conditions for the formation of the pyroelectric thin film. The thickness being greater than 0.05 μm is undesirable in that the crystallinity and the orientation of the pyroelectric layer **4** will be insufficient. Note that it is difficult to make the thickness smaller than 0.001 μm.

In the structure described above, aluminum (Al) becomes stable aluminum oxide ($Al_2O_3$) through the formation of the pyroelectric thin film without forming an intermediate oxide, unlike Ti, Co, Ni, Mg, Fe, Ca, Sr, Mn, Ba, and the like, which are easily-oxidized metals. Therefore, the crystallinity and the orientation of the pyroelectric layer formed thereon are improved. Thus, in the state where the pyroelectric device is completed, all the aluminum atoms are in the form of aluminum oxide.

Note that while the present embodiment is directed to a case where at least one of aluminum and aluminum oxide is used as the additive **3,** it is believed that the pyroelectric layer **4** will be oriented in the same manner and by the same mechanism as with aluminum and aluminum oxide also when the additive **3** is at least one additive selected from the group consisting of Ti, Co, Ni, Mg, Fe, Ca, Sr, Mn and Ba and oxides thereof. Therefore, the content c of the at least one additive selected from the group consisting of Ti, Co, Ni, Mg, Fe, Ca, Sr, Mn and Ba and oxides thereof with respect to that of the noble metal in the first electrode layer **2** is preferably $0 < c \leq 20$ mol%.

Moreover, it is preferred that the pyroelectric layer **4** further contains AOn (A is Mg or Mn, wherein n=1 if A is Mg, and n=2 if A is Mn) at a composition represented as:

$$(1-z)\{(Pb_{(1-y)}La_y)Ti_{(1-y/4)}O_3\}+zAOn$$

$$(\text{where } 0 < y \leq 0.2 \text{ and } 0 < z \leq 0.1)$$

or

$$(1-z)\{(Pb_{(1-y)}La_y)(Zr_xTi_{(1-x)})_{(1-y/4)}O_3\}+zAOn$$

$$(\text{where } 0 < x \leq 0.2 \text{ or } 0.55 \leq x < 0.8, \ 0 < y \leq 0.2 \text{ and } 0 < z \leq 0.1).$$

This is because containing MgO or $MnO_2$ at such a composition further improves the crystallinity of the pyroelectric material and increases the pyroelectric coefficient while reducing the dielectric loss, thus improving the performance of the pyroelectric device.

The primary component of the first electrode layer **2** is a noble metal. A noble metal can be used desirably as an electrode because it is not easily oxidized. Specifically, it is preferred that the first electrode layer **2** is composed of at least one noble metal selected from the group consisting of Pt, Ir, Pd and Ru.

Moreover, an appropriate thickness of the pyroelectric layer **4** is 0.5 to 5 μm. The thickness being less than 0.5 μm is undesirable in that the degree of orientation along the tetragonal (001) plane or the rhombohedral (100) plane will be low, and the thickness being greater than 5 μm is also undesirable in that the pyroelectric response will be poor due to an increase in the heat capacity.

It is preferred that the average thermal expansion coefficient of the substrate **1** of the present invention is 110% to 300%, or 20% to 100%, of that of the pyroelectric layer **4**. In other words, it is preferred that $1.1\beta \leq \alpha \leq 3\beta$ or $0.2\beta \leq \alpha \leq \beta$, where $\alpha$ is the average thermal expansion coefficient of the substrate **1,** and $\beta$ is that of the pyroelectric layer **4.** The average thermal expansion coefficient as used herein refers to the average of thermal expansion coefficient values across the temperature range of 20 to 700°C. This is because during the cooling process (which is after the pyroelectric layer **4** is formed at 500 to 700°C until it is cooled to room temperature), the substrate **1** contracts greater than the pyroelectric layer **4** to give a compressive stress upon the pyroelectric layer **4,** thus promoting the preferential orientation along the (001) plane, or the substrate **1** contracts less than the pyroelectric layer **4** to give a tensile stress upon the pyroelectric layer **4,** thus promoting the preferential orientation along the (100) plane.

If the average thermal expansion coefficient of the substrate **1** is less than 110% of that of the pyroelectric layer **4,** there is little compressive stress upon the pyroelectric layer **4.** This is undesirable where the pyroelectric layer **4** has a tetragonal perovskite crystalline structure because the preferential orientation along the (001) plane will not be promoted. However, where the pyroelectric layer **4** is made of a pyroelectric material that has a rhombohedral perovskite crystalline structure whose Zr content is large, preferential orientation along the (100) plane is obtained and polarization occurs between the two electrodes even with such an average thermal expansion coefficient. Nevertheless, the average thermal expansion coefficient of the substrate **1** being less than 20% of that of the pyroelectric layer **4** is undesirable in that a crack, peeling, or the like, occurs in the electrode layers **2** and **6** and the pyroelectric layer **4** even if the pyroelectric layer **4** is made of a pyroelectric material having a rhombohedral perovskite crystalline structure.

The average thermal expansion coefficient of the substrate **1** being greater than 300% of that of the pyroelectric layer **4** is undesirable in that a crack, peeling, or the like, occurs in the electrode layers **2** and **6** and the pyroelectric layer **4.**

Now, a manufacturing method of the present embodiment will be described with reference to FIG. **2.**

A first step S1 is a step of forming the first electrode layer **2** on the substrate **1.** The method for forming the first electrode layer **2** may be vacuum evaporation, sputtering, an electron beam vapor deposition method, a laser ablation method, etc.

The substrate **1** may be any of various materials, including a glass plate, a metal plate, a silicon plate, an alumina plate and a ceramic plate. The first electrode layer **2** is made of a noble metal containing at least one of aluminum and aluminum oxide. Specifically, the noble metal is preferably at least one selected from the group consisting of Pt, Ir, Pd and Ru.

In the present embodiment, atoms of at least one of aluminum and aluminum oxide are interspersed as the additive **3** in the noble metal of the first electrode layer **2.** The maximum length of the additive **3** exposed on the first electrode layer **2** is preferably 0.002 μm or less. In the following step, the pyroelectric layer **4** grows while being preferentially oriented along the tetragonal (001) plane with the particles of the additive **3** being crystal nuclei.

Moreover, it is preferred that the content of the additive **3** in the first electrode layer **2** is greater than 0 and is less than or equal to 20 mol% with respect to that of the noble metal.

Then, a second step S2 is a step of forming the pyroelectric layer **4** on the first electrode layer **2.** The method for forming the pyroelectric layer **4** may be a sputtering method, an electron beam vapor deposition method, a laser ablation method, or the like.

The pyroelectric layer **4** includes a pyroelectric material of a perovskite crystalline structure having a composition represented as:

$$(Pb_{(1-y)}La_y)Ti_{(1-y/4)}O_3$$

$$(\text{where } 0 < y \leq 0.2)$$

or

$$(Pb_{(1-y)}La_y)(Zr_xTi_{(1-x)})_{(1-y/4)}O_3$$

$$(\text{where } 0 < x \leq 0.2 \text{ or } 0.55 \leq x < 0.8 \text{ and } 0 < y \leq 0.2).$$

Thus, desirable pyroelectric characteristics are obtained.

The pyroelectric material, which is formed on areas of the surface of the first electrode layer **2** where no particle of the additive **3** is present, is either amorphous or (111)- or (110)-oriented, and the conditions are set so that the thickness thereof is 0.05 μm or less.

Moreover, it is preferred that the pyroelectric layer **4** further contains AOn (A is Mg or Mn, wherein n=1 if A is Mg, and n=2 if A is Mn) at a composition represented as:

$$(1-z)\{(Pb_{(1-y)}La_y)Ti_{(1-y/4)}O_3\}+zAOn$$

$$(\text{where } 0 < y \leq 0.2 \text{ and } 0 < z \leq 0.1)$$

or

$$(1-z)\{(Pb_{(1-y)}La_y)(Zr_xTi_{(1-x)})_{(1-y/4)}O_3\}+zAOn$$

(where $0<x\leq0.2$ or $0.55\leq x<0.8$, $0<y\leq0.2$ and $0<z\leq0.1$).

Furthermore, the pyroelectric layer **4** is formed so that the thickness thereof is 0.5 to 5 μm. The thickness being less than 0.5 μm is undesirable in that the pyroelectric layer **4** will have a low degree of orientation along the tetragonal (001) plane or the rhombohedral (100) plane, and the thickness being greater than 5 μm is also undesirable in that the pyroelectric layer **4** will have a poor pyroelectric response due to an increase in the heat capacity thereof.

In the second step S2, the pyroelectric layer **4** is formed on the first electrode **2** at a temperature of 500 to 700°C and cooled to room temperature. Therefore, where the pyroelectric material is PLT or PLZT whose Zr content is 0 to 20%, it is preferred to use the substrate **1** whose average thermal expansion coefficient is 110 to 300% of that of the pyroelectric layer **4,** whereby in the process of cooling down to room temperature, the substrate **1** contracts greater than the pyroelectric layer **4** to give a compressive stress upon the pyroelectric layer **4,** thus promoting the preferential orientation along the (001) plane. Where the pyroelectric material is PLZT whose Zr content is 55 to 80%, it is preferred to use the substrate **1** whose the average thermal expansion coefficient is 20 to 100% of that of the pyroelectric layer **4,** whereby in the process of cooling down to room temperature, the pyroelectric layer **4** contracts greater than the substrate **1** to give a tensile stress upon the pyroelectric layer **4,** thus promoting the preferential orientation along the (100) plane.

Then, a third step S3 is a step of forming the second electrode layer **6** on the pyroelectric layer **4.** A conductive metal or alloy, e.g., a metal such as Pt, Au or Cu or an alloy such as Ni-Cr, can be used for the second electrode layer **6.** The method for forming the second electrode layer **6** may be vacuum evaporation, sputtering, an electron beam vapor deposition method, a laser ablation method, etc.

With the manufacturing method described above, the pyroelectric layer **4** is formed directly on the first electrode layer **2** without forming an intermediate layer therebetween, thereby reducing the number of steps, reducing variations in the pyroelectric characteristics and improving the mass-production yield as compared with conventional manufacturing methods.

In the manufacturing method described above, if the first and third steps S1 and S3 are performed by a vacuum evaporation method or a sputtering method, and the second step S2 by a sputtering method, variations in the pyroelectric characteristics are reduced and the mass-production yield is improved. Moreover, other than at least one of aluminum and aluminum oxide, the additive may be at least one additive selected from the group consisting of Ti, Co, Ni, Mg, Fe, Ca, Sr, Mn, Ba and Al and oxides thereof.

Now, an infrared radiation sensor using a pyroelectric device as described above will be described.

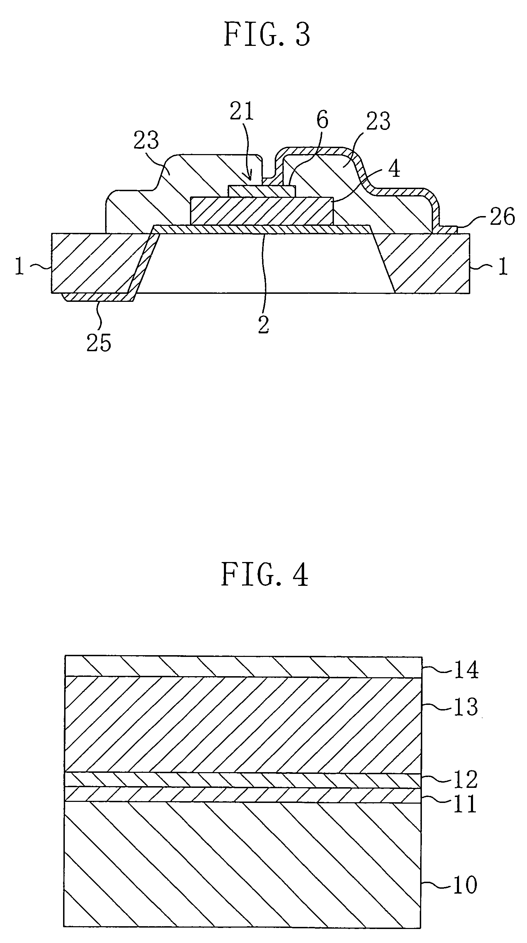

Referring to FIG. **3,** an infrared radiation sensor of the present embodiment includes a pyroelectric device **21** and two output terminals **25** and **26** for outputting an electric signal from the pyroelectric device **21.** The pyroelectric device **21** includes the first electrode layer **2** provided on the substrate **1,** the pyroelectric layer **4** provided on the first electrode layer **2,** and the second electrode layer **6** provided on the pyroelectric layer **4.** The components and the manufacturing method for the pyroelectric device **21** are as described above. Moreover, a portion of the substrate **1** is etched away so that the first electrode layer **2** is directly irradiated with infrared rays. The output terminals **25** and **26,** being metal lines, are connected to the first electrode **2** and the second electrode **6,** respectively. Note that reference numeral **23** is an insulating film.

The pyroelectric device **21** is irradiated with infrared rays coming from the outside to change the temperature of the pyroelectric device **21,** and the polarization of the pyroelectric material is changed by the temperature change. The generated electric charge is taken out through the output terminals **25** and **26.** Thus, the device can be used as an infrared radiation sensor.

Since the infrared radiation sensor as described above is produced by forming a first electrode layer a pyroelectric layer and a second electrode layer on an inexpensive substrate made of a glass, a stainless steel, alumina, silicon, or the like, using a sputtering method, or the like, it can be easily manufactured at a low cost with a desirable mass-production yield, and the pyroelectric layer has desirable crystallinity and orientation. Thus, it is possible to obtain an infrared radiation sensor that is inexpensive and has desirable pyroelectric characteristics while reducing variations in the pyroelectric characteristics.

EXAMPLES

Now, the present invention will be described in greater detail by way of examples.

EXAMPLE 1

A Pt alloy target containing 2 mol% of Al was sputtered for 15 minutes onto a substrate made of a soda-lime glass having a thickness of 1.0 mm and an average thermal expansion coefficient of $90 \times 10^{-7}/°C$ while heating the substrate to $400°C$ and applying a high-frequency power of 200 W thereto in an argon gas at 1 Pa, to obtain a first electrode layer having a thickness of $0.20 \mu m$.

An analysis of the first electrode layer with an X-ray diffraction method showed that the layer was oriented along the (111) plane and an analysis thereof with X-ray photoelectron spectroscopy (XPS) showed that the Al content was 2.2 mol%.

Then, a sinter target ($Pb_{0.90}La_{0.10}Ti_{0.975}O_3$) was sputtered for 3 hours onto the first electrode layer while heating the substrate to $550°C$ and applying a high-frequency power of 250 W thereto in a mixed atmosphere of argon and oxygen (gas volume ratio: $Ar:O_2=19:1$) at a degree of vacuum of 0.3 Pa, to obtain a pyroelectric layer having a thickness of $3.0 \mu m$.

The pyroelectric layer grew with Al atoms interspersed across the surface of the first electrode layer as nuclei, and was oriented along the (001) plane. During the formation of the pyroelectric layer, Al formed $Al_2O_3$ whose size as exposed on the surface of the first electrode layer was $0.002 \mu m$ or less, and the pyroelectric layer grew while being oriented along the (001) plane.

While the pyroelectric material is oriented along the (111) plane in areas where Al is not present, the thickness thereof is $0.02 \mu m$ or less. By setting the thickness of the pyroelectric layer to $3.0 \mu m$, it was possible to form a pyroelectric layer with desirable crystallinity and orientation in a single production step.

An analysis of the composition of the pyroelectric layer in the present example with an X-ray microanalyzer showed that the La content was the same as that of the target, i.e., 10 mol%, confirming that the pyroelectric layer had substantially the same composition as that of the target.

Thus, the composition is represented as:

$$(Pb_{(1-y)}La_y)Ti_{(1-y/4)}O_3$$

where y=0.1.

An analysis of the crystalline structure of the pyroelectric layer with an X-ray diffraction method showed that it was a (001)-oriented tetragonal perovskite crystalline structure, with the degree $\alpha$ of orientation being 100%.

Herein, the degree of (001) orientation ("$\alpha(001)$") is defined as $\alpha(001)=I(001)/\Sigma I(hkl)$. $I(001)$ is the diffraction peak intensity for a Cu-K$\alpha$ $2\theta$ value around $22°$ in an X-ray diffraction method, and $\Sigma I(hkl)$ is the sum of diffraction peak intensities from various crystal faces for a Cu-K$\alpha$ $2\theta$ range of $10°$ to $70°$ in an X-ray diffraction method.

Note that the (002) plane and the (200) plane are not included in $\Sigma I(hkl)$ as they are equivalent to the (001) plane and the (100) plane.

The average thermal expansion coefficient of the substrate in the present example is 145% of that of the pyroelectric layer, thus giving a compressive stress upon the pyroelectric layer and promoting the preferential orientation along the tetragonal (001) plane.

Finally, an Ni-Cr second electrode layer having a thickness of $0.2 \mu m$ was formed on the pyroelectric layer by a sputtering method.

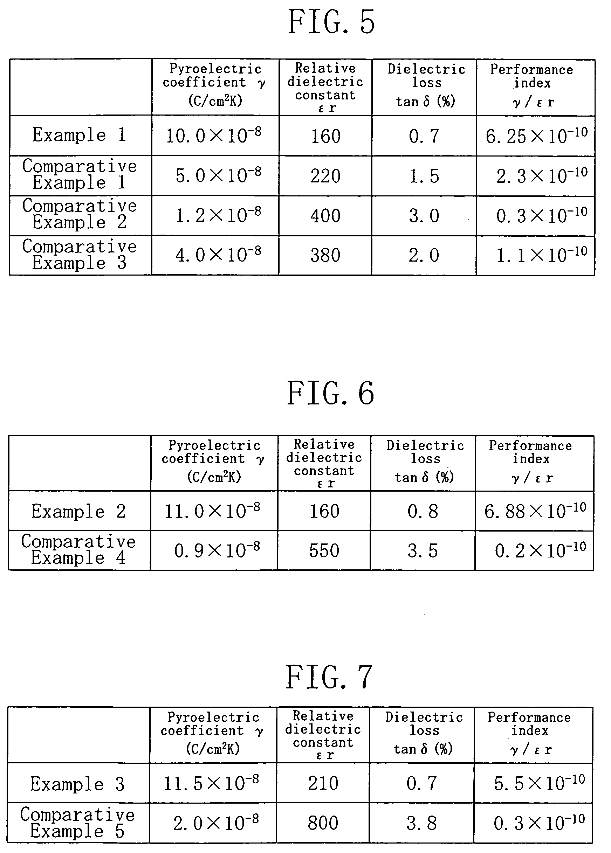

An infrared radiation sensor as shown in FIG. **4** was produced by using a pyroelectric device as described above. Moreover, a pyroelectric current flowing between the first electrode layer and the second electrode layer in the pyroelectric device in response to a temperature change was measured by a pA meter to calculate the pyroelectric coefficient. Moreover, the relative dielectric constant $\varepsilon r$ was calculated based on the measurement of an electric capacity between the first electrode layer and the second electrode layer using an LCR meter under a 1 kHz and 1 V condition. The dielectric loss was measured by an LCR meter under a similar condition. The pyroelectric characteristics are shown in FIG. **5.**

COMPARATIVE EXAMPLE 1

In Comparative Example 1, a pyroelectric device having the same structure as that of Example 1 was produced except that Pt was used for the first electrode layer and an MgO intermediate layer having a thickness of $0.2 \mu m$ was formed on the first electrode layer.

The pyroelectric layer of this comparative example showed a (001)-oriented tetragonal perovskite crystalline structure, with the degree $\alpha$ of orientation being 80%.

As in Example 1, the pyroelectric characteristics of Comparative Example 1 are shown in FIG. **5**. Herein, a larger pyroelectric coefficient, a smaller relative dielectric constant, a smaller dielectric loss and a larger figure of merit each indicate a better pyroelectric characteristic.

As can be seen from FIG. **5**, Example 1 has a pyroelectric coefficient twice that of Comparative Example 1, a relative dielectric constant 0.73 times that of Comparative Example 1, a dielectric loss 0.46 times that of Comparative Example 1 and a pyroelectric coefficient/relative dielectric constant (the figure of merit of the pyroelectric device) about 2.7 times that of Comparative Example 1. Thus, Example 1 is superior to Comparative Example 1 in every parameter and it is clear that Example 1 has superior characteristics as a pyroelectric device.

Moreover, 100 pyroelectric devices of Example 1 and 100 pyroelectric devices of Comparative Example 1 were produced, and it was indicated that the yield for devices having a pyroelectric coefficient of 5.0 (the average value for Comparative Example 1) or more was 99% for Example 1 and 50% for Comparative Example 1. The pyroelectric coefficient variation $\sigma$ with respect to the value shown in FIG. **5** was $0.5 \times 10^{-8}$ for Example 1 and $1.1 \times 10^{-8}$ for Comparative Example 1, indicating that Example 1 had a smaller pyroelectric characteristics variation, a smaller number of production steps and an improved mass-production yield, as compared with Comparative Example 1.

COMPARATIVE EXAMPLE 2

In Comparative Example 2, a pyroelectric device having the same structure as that of Example 1 was produced except that the first electrode layer was made only of Pt containing no Al.

The pyroelectric layer of this comparative example was preferentially oriented along the (111) plane, with the degree $\alpha$ of (001) orientation being 5% or less. Referring to FIG. **5,** the pyroelectric coefficient was 1/8 that of Example 1, the relative dielectric constant was about 2.5 times that of Example 1, the dielectric loss was 4.3 times that of Example 1 and the figure of merit was about 1/20 that of Example 1. Thus, it is clear that Example 1 has better pyroelectric characteristics as a pyroelectric device than Comparative Example 2.

COMPARATIVE EXAMPLE 3

In Comparative Example 3, a pyroelectric device having the same structure as that of Example 1 was produced except that a quartz glass substrate whose average thermal expansion coefficient is $5 \times 10^{-7}/{}^{\circ}C$, about 8.1% of that of the pyroelectric layer, was used instead of a soda-lime glass substrate used in Example 1.

The pyroelectric layer of this comparative example showed a (100)-oriented tetragonal perovskite crystalline structure. However, the pyroelectric device of Comparative Example 3 had a crack between the electrode layer and the pyroelectric layer, and could not be used as an infrared radiation sensor.

The pyroelectric characteristics of this comparative example are shown in FIG. 5.

As can be seen from the table, Example 1 has a pyroelectric coefficient 2.5 times that of Comparative Example 3, a relative dielectric constant 0.42 times that of Comparative Example 3, a dielectric loss 0.35 times that of Comparative Example 3 and a figure of merit about 5.7 times that of Comparative Example 3. Thus, Example 1 is superior to Comparative Example 3 in every parameter and it is clear that Example 1 has superior characteristics as a pyroelectric device.

EXAMPLE 2

A stainless steel substrate having a thickness of 0.25 mm and a diameter of 4 inches was used in the present example. The substrate has an average thermal expansion coefficient of $180 \times 10^{-7}/{}^{\circ}C$, 300% of that of the pyroelectric layer.

In this example, the first electrode layer is an Ir film having a thickness of 0.25 $\mu$m and containing 5 mol% of Al, the pyroelectric layer is a PLMT thin film ($0.96\{Pb_{0.95}La_{0.05}Ti_{0.9875}O_3\}+0.04MgO$) having a thickness of 2.5 $\mu$m, and the second electrode layer is a Pt film having a thickness of 0.1 $\mu$m.

The composition of the pyroelectric layer is represented as:

$$(1-z)\{(Pb_{(1-y)}La_y)Ti_{(1-y/4)}O_3\}+zAOn$$

where y=0.05, z=0.04, A=Mg and n=1.

The pyroelectric layer of the present example was preferentially oriented along the (001) plane, with the degree $\alpha$ of orientation being 98%.

An Ir target and an Al target were sputtered by a multi-target sputtering apparatus for 20 minutes while heating the substrate to $400^{\circ}C$ and applying a high-frequency power of 100 W to the Ir target and 50 W to the Al target for a simultaneous discharge in a mixed atmosphere of argon and oxygen (gas volume ratio: Ar:$O_2$=19:1) at 1 Pa, to obtain the first electrode layer.

An analysis on the chemical composition and the crystalline structure of the first electrode layer, before the formation of the pyroelectric layer, showed that the electrode thin film was (111)-oriented and contained 5.0 mol% of Al.

A sinter target of PLMT (with addition of 5 mol% of La and 4 mol% of Mg) was sputtered for 3 hours while heating the substrate to 600°C and applying a high-frequency power of 250 W thereto in a mixed atmosphere of argon and oxygen (gas volume ratio: $Ar:O_2=19:1$) at a degree of vacuum of 0.3 Pa, to obtain the pyroelectric layer.

A Pt pellet was irradiated with an electron beam to be evaporated onto the pyroelectric layer using a vacuum evaporation apparatus in a vacuum of $5 \times 10^{-4}$ Pa with the substrate being at room temperature, to obtain the second electrode layer.

The chemical composition and the crystalline structure of the pyroelectric layer were examined as in Example 1 before the formation of the second electrode layer, indicating that the chemical composition was substantially the same as that of the target and the crystalline structure was a tetragonal perovskite crystalline structure with the degree $\alpha$ of (001) orientation being 98%.

COMPARATIVE EXAMPLE 4

In Comparative Example 4, a pyroelectric device having the same structure as that of Example 2 was produced except that the first electrode layer was made only of Ir containing no Al.

The pyroelectric layer of this comparative example was preferentially oriented along the (111) plane, with the degree of (001) orientation being 7% or less.

The pyroelectric characteristics of Example 2 and Comparative Example 4 are shown in FIG. **6.**

As can be seen from FIG. **6,** Example 2 has a pyroelectric coefficient about 12 times that of Comparative Example 4, a relative dielectric constant 29% of that of Comparative Example 4, a dielectric loss 0.23 times that of Comparative Example 4, and a figure of merit about 34 times that of Comparative Example 4. Thus, it is clear that Example 2 has superior characteristics as a pyroelectric device to Comparative Example 4.

Moreover, 100 pyroelectric devices of Example 2 and 100 pyroelectric devices of Comparative Example 4 were produced, and it was indicated that the yield for devices having a pyroelectric coefficient of 0.9 (the average value for Comparative Example 4) or more was 99% for Example 2 and 50% for Comparative Example 4. The pyroelectric coefficient variation σ with respect to the value shown in FIG. **6** was $0.5\times10^{-8}$ for Example 2 and $0.6\times10^{-8}$ for Comparative Example 4, indicating that Example 2 had a smaller pyroelectric characteristics variation, a smaller number of production steps and an improved mass-production yield, as compared with Comparative Example 4.

EXAMPLE 3

An alumina substrate having a thickness of 0.5 mm was used in the present example.

The average thermal expansion coefficient of the substrate is $80\times10^{-7}/°C$, 133% of that of the pyroelectric layer.

In the present example, the first electrode layer is an Pd film having a thickness of 0.3 μm and containing 8 mol% of Al, the pyroelectric layer is a PLZT thin film ($Pb_{0.95}La_{0.05}Zr_{0.09875}Ti_{0.88875}O_3$) having a thickness of 3.5 μm, and the second electrode layer is a Cu film having a thickness of 0.05 μm.

A pellet obtained by mixing together Pd and Al at 9:1 was irradiated with an electron beam to simultaneously evaporate Pd and Al onto the substrate by a vacuum evaporation method using a vacuum evaporation apparatus while heating the substrate to 400°C in a vacuum of $5\times10^{-4}$ Pa, to obtain the first electrode layer.

The first electrode layer was amorphous Pd containing 8 mol% of Al.

A sinter target of PLZT (with addition of 10 mol% of Zr) was sputtered for 3 hours while heating the substrate to 650°C and applying a high-frequency power of 250 W thereto in a mixed atmosphere of argon and oxygen (gas volume ratio: $Ar:O_2=19.5:0.5$) at a degree of vacuum of 0.2 Pa, to obtain the pyroelectric layer.

The chemical composition and the crystalline structure of the pyroelectric layer were examined as in Example 1 before the formation of the second electrode layer.

The chemical composition of the pyroelectric layer was the same as that of the target, and was represented as:

$$(Pb_{(1-y)}La_y)(Zr_xTi_{(1-x)})_{(1-y/4)}O_3$$

where y=0.05 and x=0.1.

The crystalline structure of the pyroelectric layer was a tetragonal perovskite crystalline structure with the degree $\alpha$ of (001) orientation being 95%.

A Cu pellet was irradiated with an electron beam to be evaporated onto the pyroelectric layer using a vacuum evaporation apparatus in a vacuum of $5 \times 10^{-4}$ Pa with the substrate being at room temperature, to obtain the second electrode layer.

COMPARATIVE EXAMPLE 5

In Comparative Example 5, a pyroelectric device having the same structure as that of Example 3 was produced except that the first electrode layer was made only of Pd containing no Al.

The pyroelectric layer of this comparative example was preferentially oriented along the (111) plane, with the degree $\alpha$ of (001) orientation being 3% or less.

The pyroelectric characteristics of Example 3 and Comparative Example 5 are shown in FIG. 7.

As can be seen from FIG. **7**, Example 3 has a pyroelectric coefficient 5.75 times that of Comparative Example 5, a relative dielectric constant about 1/4 that of Comparative Example 5, a dielectric loss about 0.18 times that of Comparative Example 5 and a figure of merit 18 times that of Comparative Example 5. Thus, it is clear that Example 3 has superior characteristics as a pyroelectric device to Comparative Example 5.

Moreover, 100 pyroelectric devices of Example 3 and 100 pyroelectric devices of Comparative Example 5 were produced, and it was indicated that the yield for devices having a pyroelectric coefficient of 2.0 (the average value for Comparative Example 5) or more was 100% for Example 3 and 50% for Comparative Example 5. The pyroelectric coefficient variation $\sigma$ with respect to the value shown in FIG. **7** was $0.7 \times 10^{-8}$ for Example 3 and $1.0 \times 10^{-8}$ for Comparative Example 5, indicating that Example 3 had a smaller pyroelectric characteristics variation, a smaller number of production steps and an improved mass-production yield, as compared with Comparative Example 5.

EXAMPLE 4

A crystallized glass substrate having a thickness of 1.0 mm was used in the present example.

The substrate has an average thermal expansion coefficient of $120 \times 10^{-7}/^\circ$C, 200% of that of the pyroelectric layer.

In this example, the first electrode layer is an Ru film having a thickness of 0.4 $\mu$m and containing 1 mol% of $Al_2O_3$, the pyroelectric layer is a PLMT film ($0.92\{Pb_{0.85}La_{0.15}Ti_{0.9625}O_3\}+0.08MnO_2$) having a thickness of 1.5 $\mu$m, and the second electrode layer is an Au film having a thickness of 0.2 $\mu$m.

A target obtained by mixing together Ru powder and $Al_2O_3$ powder and press-forming the mixture was sputtered by a sputtering apparatus for 10 minutes while heating the substrate to 500°C and applying a high-frequency power of 100 W to the target in an argon atmosphere at 0.5 Pa, to obtain the first electrode layer.

The first electrode layer was an Ru film preferentially oriented along the (111) plane and containing 1.0 mol% of $Al_2O_3$.

A sinter target of PLT (with addition of 15 mol% of La) and an Mn target were sputtered by a multi-target sputtering apparatus for 4 hours while heating the substrate to 550°C and applying a high-frequency power of 200 W to the PLT target and 50 W to the Mn target for a simultaneous discharge in a mixed atmosphere of argon and oxygen (gas volume ratio: Ar:$O_2$=18:2) at a degree of vacuum of 1.0 Pa, to obtain the pyroelectric layer.

The chemical composition and the crystalline structure of the pyroelectric layer were examined as in Example 1 before the formation of the second electrode layer. The chemical composition of the pyroelectric layer was represented as:

$$(1-z)\{(Pb_{(1-y)}La_y)Ti_{(1-y/4)}O_3\}+zAOn$$

where z=0.08, y=0.15, A=Mn and n=2.

The crystalline structure was a tetragonal perovskite crystalline structure with the degree $\alpha$ of (001) orientation being 96%.

An Au pellet was irradiated with an electron beam onto the pyroelectric layer by a vacuum evaporation method using a vacuum evaporation apparatus with the substrate being at room temperature in a vacuum of $5 \times 10^{-4}$ Pa, to obtain the second electrode layer.

COMPARATIVE EXAMPLE 6

In Comparative Example 6, a pyroelectric device having the same structure as that of Example 4 was produced except that the first electrode layer was made only of Ru containing no $Al_2O_3$.

The pyroelectric layer of this comparative example was preferentially oriented along the (111) plane, with the degree $\alpha$ of (001) orientation being 10% or less.

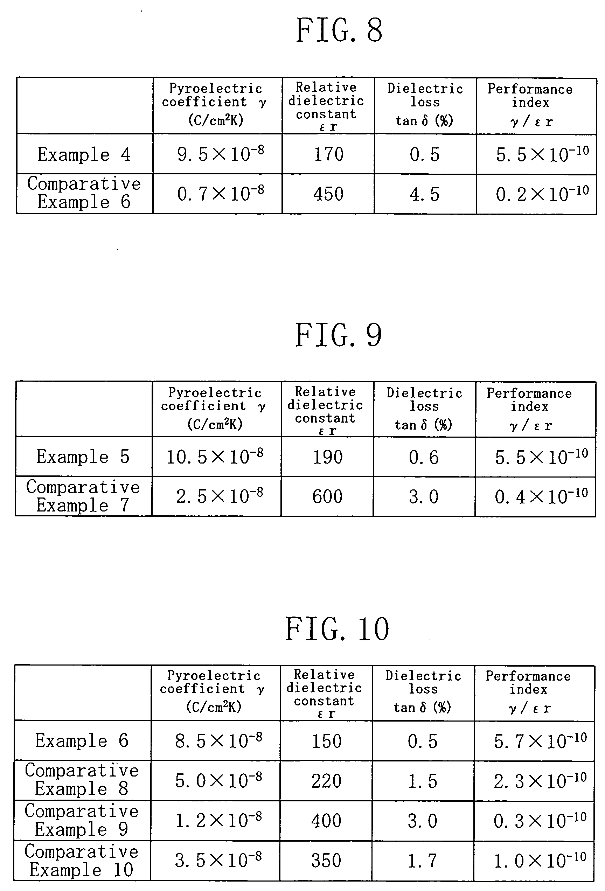

The pyroelectric characteristics of Example 4 and Comparative Example 6 are shown in FIG. **8.**

As can be seen from FIG. **8,** Example 4 has a pyroelectric coefficient 13.6 times that of Comparative Example 6, a relative dielectric constant 0.37 times that of Comparative Example 6, a dielectric loss 1/9 that of Comparative Example 6 and a figure of merit 27.5 times that of Comparative Example 6. Thus, it is clear that Example 4 has superior characteristics as a pyroelectric device to Comparative Example 6.

Moreover, 100 pyroelectric devices of Example 4 and 100 pyroelectric devices of Comparative Example 6 were produced, and it was indicated that the yield for devices having a pyroelectric coefficient of 0.7 (the average value for Comparative Example 6) or more was 100% for Example 4 and 50% for Comparative Example 6. The pyroelectric coefficient variation $\sigma$ with respect to the value shown in FIG. **8** was $0.4\times10^{-8}$ for Example 4 and $0.5\times10^{-8}$ for Comparative Example 6, indicating that Example 4 had a smaller pyroelectric characteristics variation, a smaller number of production steps and an improved mass-production yield, as compared with Comparative Example 6.

EXAMPLE 5

A soda-lime glass substrate having a thickness of 0.5 mm was used in the present example. The substrate has an average thermal expansion coefficient of $90\times10^{-7}/°C$, about 150% of that of the pyroelectric layer.

In the present example, the first electrode layer is a Pt film having a thickness of 0.1 $\mu$m and containing 18 mol% of Al, the pyroelectric layer is an MgO-added PLZT thin film $(0.9\{(Pb_{0.8}La_{0.2})(Zr_{0.19}Ti_{0.76})O_3\}+0.1MgO)$ having a thickness of 3.2 $\mu$m, and the second electrode layer is a Pt film having a thickness of 0.05 $\mu$m.

The composition of the pyroelectric layer is represented as:

$$(1-z)\{(Pb_{(1-y)}La_y)(Zr_xTi_{(1-x)})_{(1-y/4)}O_3\}+zAOn$$

where z=0.1, y=0.2, x=0.2, A=Mg and n=1.

The pyroelectric layer of the present example was preferentially oriented along the (001) plane, with the degree $\alpha$ of orientation being 97%.

A Pt target and an Al target were sputtered by a multi-target sputtering apparatus for 10 minutes while heating the substrate to 400°C and applying a high-frequency power of 100 W to the Pt target and 50 W to the Al target for a simultaneous discharge in a mixed atmosphere of argon and oxygen (gas volume ratio: $Ar:O_2=18:2$) at 1 Pa, to obtain the first electrode layer.

An analysis on the chemical composition and the crystalline structure of the first electrode layer, before the formation of the pyroelectric layer, showed that the electrode thin film was non-crystalline (amorphous) and contained 18.0 mol% of Al.

A sinter target of PLMZT (with addition of 20 mol% of La, 20 mol% of Zr and 10 mol% of MgO) was sputtered for 4 hours while heating the substrate to 650°C and applying a high-frequency power of 250 W thereto in a mixed atmosphere of argon and oxygen (gas volume ratio: $Ar:O_2=19.5:0.5$) at a degree of vacuum of 0.4 Pa, to obtain the pyroelectric layer.

A Pt pellet was irradiated with an electron beam to be evaporated onto the pyroelectric layer using a vacuum evaporation apparatus in a vacuum of $5\times10^{-4}$ Pa with the substrate being at room temperature, to obtain the second electrode layer.

The chemical composition and the crystalline structure of the pyroelectric layer were examined as in Example 1 before the formation of the second electrode layer, indicating that the chemical composition was substantially the same as that of the target and the crystalline structure was a tetragonal perovskite crystalline structure with the degree $\alpha$ of (001) orientation being 97%.

COMPARATIVE EXAMPLE 7

In Comparative Example 7, a pyroelectric device having the same structure as that of Example 5 was produced except that the first electrode layer was made only of Pt containing no Al.

The pyroelectric layer of this comparative example was preferentially oriented along the (111) plane, with the degree $\alpha$ of (001) orientation being 10% or less.

The pyroelectric characteristics of Example 5 and Comparative Example 7 are shown in FIG. **9.**

As can be seen from FIG. **9,** Example 5 has a pyroelectric coefficient about 4 times that of Comparative Example 7, a relative dielectric constant 0.32 times that of Comparative Example 7, a dielectric loss 0.2 times that of Comparative Example 7 and a figure of merit about 13 times that of Comparative Example 7. Thus, it is clear that Example 5 has superior characteristics as a pyroelectric device to Comparative Example 7.

Moreover, 100 pyroelectric devices of Example 5 and 100 pyroelectric devices of Comparative Example 7 were produced, and it was indicated that the yield for devices having a pyroelectric coefficient of 2.5 (the average value for Comparative Example 7) or more was 97% for Example 5 and 50% for Comparative Example 7. The pyroelectric coefficient variation σ with respect to the value shown in FIG. **9** was $0.6\times10^{-8}$ for Example 5 and $0.8\times10^{-8}$ for Comparative Example 7, indicating that Example 5 had a smaller pyroelectric characteristics variation, a smaller number of production steps and an improved mass-production yield, as compared with Comparative Example 7.

EXAMPLE 6

A Pt alloy target containing 2 mol% of Ti was sputtered for 15 minutes onto a substrate made of a soda-lime glass having a thickness of 1.0 mm and an average thermal expansion coefficient of $90\times10^{-7}/°C$ while heating the substrate to 400°C and applying a high-frequency power of 200 W thereto in an argon gas at 1 Pa, to obtain a first electrode layer having a thickness of 0.20 μm.

An analysis of the first electrode layer with an X-ray diffraction method showed that the layer was oriented along the (111) plane and an analysis thereof with X-ray photoelectron spectroscopy (XPS) showed that the Ti content was 2.1 mol%.

Then, a sinter target ($Pb_{0.90}La_{0.10}Ti_{0.975}O_3$) was sputtered for 3 hours onto the first electrode layer while heating the substrate to 550°C and applying a high-frequency power of 250 W thereto in a mixed atmosphere of argon and oxygen (gas volume ratio: $Ar:O_2=19:1$) at a degree of vacuum of 0.3 Pa, to obtain a pyroelectric layer having a thickness of 3.0 μm.

The pyroelectric layer grew with Ti atoms interspersed across the surface of the first electrode layer as nuclei, and was oriented along the (001) plane. During the formation of the pyroelectric layer, Ti, which is easily oxidized, formed titanium oxide whose size as exposed on the surface of the first electrode layer was 0.002 μm or less, and the pyroelectric layer grew while being oriented along the (001) plane.

While the pyroelectric layer is oriented along the (111) plane in areas where Ti is not present, the thickness thereof is 0.02 μm or less. By setting the thickness of the pyroelectric layer to 3.0 μm, it was possible to form a pyroelectric layer with desirable crystallinity and orientation in a single production step.

An analysis of the composition of the pyroelectric layer in the present example with an X-ray microanalyzer showed that the La content was the same as that of the target, i.e., 10 mol%.

Thus, the composition is represented as:

$$(Pb_{(1-y)}La_y)Ti_{(1-y/4)}O_3$$

where y=0.1.

An analysis of the crystalline structure of the pyroelectric layer with an X-ray diffraction method showed that it was a (001)-oriented tetragonal perovskite crystalline structure, with the degree α of orientation being 100%.

The average thermal expansion coefficient of the substrate in the present example is 145% of that of the pyroelectric layer, thus giving a compressive stress upon the pyroelectric layer and promoting the preferential orientation along the tetragonal (001) plane.

Finally, an Ni-Cr second electrode layer having a thickness of 0.2 μm was formed on the pyroelectric layer by a sputtering method.

An infrared radiation sensor as shown in FIG. **4** was produced by using a pyroelectric device as described above. Moreover, a pyroelectric current flowing between the first electrode layer and the second electrode layer in the pyroelectric device in response to a temperature change was measured by a pA meter to calculate the pyroelectric coefficient. Moreover, the dielectric constant εr was calculated based on the measurement of an electric capacity between the first electrode layer and the second electrode layer using an LCR meter under a 1 kHz and 1 V condition. The dielectric loss was measured by an LCR meter under a similar condition.

COMPARATIVE EXAMPLE 8

In Comparative Example 8, a pyroelectric device having the same structure as that of Example 6 was produced except that Pt was used for the first electrode layer and an MgO intermediate layer having a thickness of 0.2 μm was formed on the first electrode layer.

The pyroelectric layer of this comparative example had a tetragonal perovskite crystalline structure oriented along the (001) plane and a thickness of 3.0 μm, with the degree α of (001) orientation being 80%.

The pyroelectric characteristics of Example 6 and Comparative Example 8 are shown in FIG. **10.** Note that these values are each an average value obtained from 100 pyroelectric devices of the present example or the comparative example.

As can be seen from FIG. **10,** Example 6 has a pyroelectric coefficient 1.7 times that of Comparative Example 8, a relative dielectric constant about 0.68 times that of Comparative Example 8, a dielectric loss 1/3 that of Comparative Example 8 and a pyroelectric coefficient/relative dielectric constant (the figure of merit of the pyroelectric device) about 2.5 times that of Comparative Example 8. Thus, it is clear that Example 6 has superior characteristics as a pyroelectric device and as an infrared radiation sensor.

Moreover, 100 pyroelectric devices of Example 6 and 100 pyroelectric devices of Comparative Example 8 were produced, and it was indicated that the yield for devices having a pyroelectric coefficient of 5.0 (the average value for Comparative Example 8) or more was 98% for Example 6 and 50% for Comparative Example 8. The pyroelectric coefficient variation $\sigma$ with respect to the value shown in FIG. **10** was $0.2 \times 10^{-8}$ for Example 6 and $1.0 \times 10^{-8}$ for Comparative Example 8, indicating that Example 6 had a smaller pyroelectric characteristics variation, a smaller number of production steps and an improved mass-production yield, as compared with Comparative Example 8.

COMPARATIVE EXAMPLE 9

In Comparative Example 9, a pyroelectric device having the same structure as that of Example 6 was produced except that the first electrode layer was made only of Pt containing no Ti.
The pyroelectric layer of Comparative Example 9 was preferentially oriented along the (111) plane and had a thickness of 3.2 $\mu$m, with the degree $\alpha$ of (001) orientation being 10% or less. Referring to FIG. **10,** the pyroelectric coefficient was 1/7 that of Example 6, the relative dielectric constant was about 2.7 times that of Example 6, the dielectric loss was 6 times that of Example 6 and the pyroelectric coefficient/relative dielectric constant was 1/19 that of Example 6. Thus, it is clear that Example 6 has superior pyroelectric characteristics as a pyroelectric device.

COMPARATIVE EXAMPLE 10

In Comparative Example 10, a pyroelectric device having the same structure as that of Example 6 was produced except that a quartz glass substrate whose average thermal expansion coefficient is $5 \times 10^{-7}/^{\circ}$C, about 8.1% of that of the pyroelectric layer, was used instead of a soda-lime glass substrate used in Example 6.
The pyroelectric layer of Comparative Example 10 had a tetragonal perovskite crystalline structure oriented along the (100) plane, i.e., along the a axis, and had a thickness of 2.9 $\mu$m. In contrast, Example 6 is oriented along the (001) plane, i.e., the c axis, different from the axis of orientation of Comparative Example 10. Therefore, Comparative Example 10 had a degree $\alpha$ of (001) orientation of 5% or less.
The pyroelectric characteristics of Comparative Example 10 were evaluated, indicating that Example 6 had a pyroelectric coefficient about 2.4 times that of Comparative Example 10 and a relative dielectric constant 0.43 times that of Comparative Example 10 and a dielectric loss 0.29 times that of Comparative Example 10, as shown in FIG. **10.** Moreover, the pyroelectric coefficient/relative dielectric constant is 5.7 times that of Comparative Example 10. Thus, it is clear that Example 6 has superior characteristics as a pyroelectric device.

EXAMPLE 7

A stainless steel substrate having a thickness of 0.25 mm and a diameter of 4 inches was used in the present example. The average thermal expansion coefficient of the substrate is $180 \times 10$-7$/^{\circ}$C, 300% of that of the pyroelectric layer.
In this example, the first electrode layer is an Ir film having a thickness of 0.25 $\mu$m and containing 5 mol% of Co, the pyroelectric layer is a PLMT thin film ($0.96\{Pb_{0.95}La_{0.05}Ti_{0.9875}O_3\}+0.04MgO$) having a thickness of 2.5 $\mu$m, and the second electrode layer is a Pt film having a thickness of 0.1 $\mu$m.
The composition of the pyroelectric layer is represented as:

$$(1-z)\{(Pb_{(1-y)}La_y)Ti_{(1-y/4)}O_3\}+zAOn$$

where y=0.05, z=0.04, A=Mg and n=1.
The pyroelectric layer of the present example was preferentially oriented along the (001) plane, with the degree $\alpha$ of orientation being 98%.
An Ir target and a Co target were sputtered by a multi-target sputtering apparatus for 20 minutes while heating the substrate to 400$^{\circ}$C and applying a high-frequency power of 100 W to the Ir target and 50 W to the Co target for a simultaneous discharge in a mixed atmosphere of argon and oxygen (gas volume ratio: Ar:$O_2$=19:1) at 1 Pa, to obtain the first electrode layer.
An analysis on the chemical composition and the crystalline structure of the first electrode layer, before the formation of the pyroelectric layer, showed that the Ir film was (111)-oriented and contained 5.0 mol% of Co.

A sinter target of PLMT (with addition of 5 mol% of La and 4 mol% of Mg) was sputtered for 3 hours while heating the substrate to 600°C and applying a high-frequency power of 250 W thereto in a mixed atmosphere of argon and oxygen (gas volume ratio: $Ar:O_2=19:1$) at a degree of vacuum of 0.3 Pa, to obtain the pyroelectric layer.

A Pt pellet was irradiated with an electron beam to be evaporated onto the pyroelectric layer using a vacuum evaporation apparatus in a vacuum of $5\times10^{-4}$ Pa with the substrate being at room temperature, to obtain the second electrode layer.

The chemical composition and the crystalline structure of the pyroelectric layer were examined as in Example 6 before the formation of the second electrode layer, indicating that the chemical composition was substantially the same as that of the target and the crystalline structure was a tetragonal perovskite crystalline structure with the degree $\alpha$ of (001) orientation being 98%.

COMPARATIVE EXAMPLE 11

In Comparative Example 11, a pyroelectric device having the same structure as that of Example 7 was produced except that the first electrode layer was made only of Ir containing no Co.

The pyroelectric layer of this comparative example was preferentially oriented along the (111) plane, with the degree of (001) orientation being 7% or less.

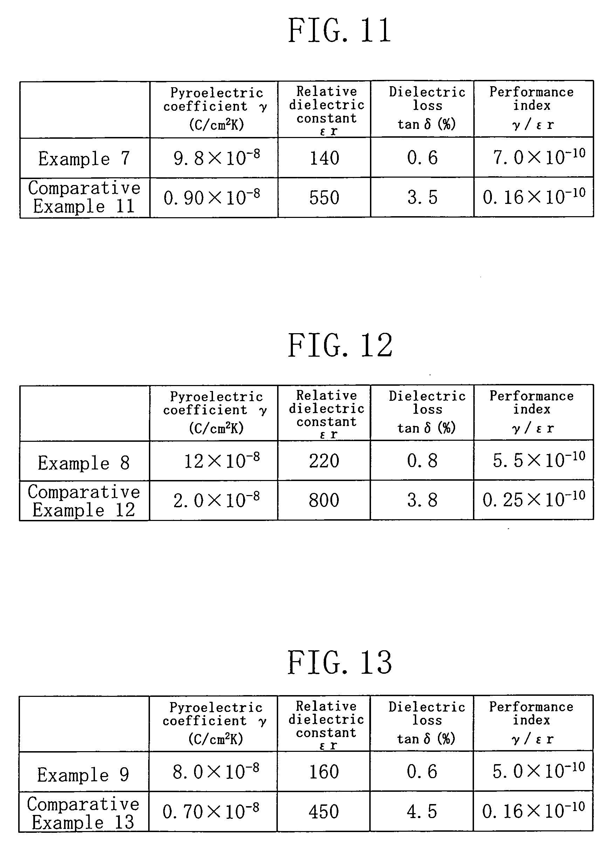

The pyroelectric characteristics of Example 7 and Comparative Example 11 are shown in FIG. **11.**

As can be seen from FIG. **11,** Example 7 has a pyroelectric coefficient 11 times that of Comparative Example 11, a relative dielectric constant about 1/4 that of Comparative Example 11, a dielectric loss about 1/6 that of Comparative Example 11 and a pyroelectric coefficient/relative dielectric constant about 44 times that of Comparative Example 11. Thus, it is clear that Example 7 has superior characteristics as a pyroelectric device.

Moreover, 100 pyroelectric devices of Example 7 and 100 pyroelectric devices of Comparative Example 11 were produced, and it was indicated that the yield for devices having a pyroelectric coefficient of 0.9 (the average value for Comparative Example 11) or more was 99% for Example 7 and 50% for Comparative Example 11. The pyroelectric coefficient variation σ with respect to the value shown in FIG. **11** was $0.3\times10^{-8}$ for Example 7 and $0.5\times10^{-8}$ for Comparative Example 11, indicating that Example 7 had a smaller pyroelectric characteristics variation and an improved mass-production yield, as compared with Comparative Example 11.

EXAMPLE 8

An alumina substrate having a thickness of 0.5 mm was used in the present example.

The average thermal expansion coefficient of the substrate is $80\times10^{-7}/°C$, 133% of that of the pyroelectric layer.

In this example, the first electrode layer is a Pd film having a thickness of 0.3 μm and containing 8 mol% of Ni, the pyroelectric layer is a PLZT thin film ($Pb_{0.95}La_{0.05}Zr_{0.09875}Ti_{0.88875}O_3$) having a thickness of 3.5 μm, and the second electrode layer is a Cu film having a thickness of 0.05 μm.

A pellet obtained by mixing together Pd and Ni at 9:1 was irradiated with an electron beam to simultaneously evaporate Pd and Ni onto the substrate by a vacuum evaporation method using a vacuum evaporation apparatus while heating the substrate to 400°C in a vacuum of $5\times10^{-4}$ Pa, to obtain the first electrode layer.

The first electrode layer had an amorphous crystalline structure containing 8 mol% of Ni. A sinter target of PLZT (with addition of 10 mol% of Zr) was sputtered for 3 hours while heating the substrate to 650°C and applying a high-frequency power of 250 W thereto in a mixed atmosphere of argon and oxygen (gas volume ratio: $Ar:O_2=19.5:0.5$) at a degree of vacuum of 0.2 Pa, to obtain the pyroelectric layer.

The chemical composition and the crystalline structure of the pyroelectric layer were examined as in Example 6 before the formation of the second electrode layer.

The chemical composition of the pyroelectric layer was the same as that of the target, and was represented as:

$$(Pb_{(1-y)}La_y)(Zr_xTi_{(1-x)})_{(1-y/4)}O_3$$

where y=0.05 and x=0.1.

The crystalline structure was a tetragonal perovskite crystalline structure with the degree $\alpha$ of (001) orientation being 92%.

A Cu pellet was irradiated with an electron beam to be evaporated onto the pyroelectric layer using a vacuum evaporation apparatus in a vacuum of $5\times10^{-4}$ Pa with the substrate being at room temperature, to obtain the second electrode layer.

COMPARATIVE EXAMPLE 12

In Comparative Example 12, a pyroelectric device having the same structure as that of Example 8 was produced except that the first electrode layer was made only of Pd containing no Ni.

The pyroelectric layer of this comparative example was preferentially oriented along the (111) plane, with the degree $\alpha$ of (001) orientation being 5% or less. The thickness was 3.8 $\mu$m.

The pyroelectric characteristics of Example 8 and Comparative Example 12 are shown in FIG. **12.**

As can be seen from FIG. **12,** Example 8 has a pyroelectric coefficient 6 times that of Comparative Example 12, a relative dielectric constant about 1/3 that of Comparative Example 12, a dielectric loss about 1/5 that of Comparative Example 12 and a pyroelectric coefficient/relative dielectric constant about 22 times that of Comparative Example 12. Thus, it is clear that Example 8 has superior characteristics as a pyroelectric device.

Moreover, 100 pyroelectric devices of Example 8 and 100 pyroelectric devices of Comparative Example 12 were produced, and it was indicated that the yield for devices having a pyroelectric coefficient of 2.0 (the average value for Comparative Example 12) or more was 100% for Example 8 and 50% for Comparative Example 12. The pyroelectric coefficient variation $\sigma$ with respect to the value shown in FIG. **12** was $0.5 \times 10^{-8}$ for Example 8 and $0.8 \times 10^{-8}$ for Comparative Example 12, indicating that Example 8 had a smaller pyroelectric characteristics variation, a smaller number of production steps and an improved mass-production yield, as compared with Comparative Example 12.

EXAMPLE 9

A crystallized glass substrate having a thickness of 1.0 mm was used in the present example.

The average thermal expansion coefficient of the substrate is $120 \times 10^{-7}/°C$, 200% of that of the pyroelectric layer.

In this example, the first electrode layer is an Ru film having a thickness of 0.4 $\mu$m and containing 1 mol% of Ba, the pyroelectric layer is a PLMT thin film ($0.92\{Pb_{0.85}La_{0.15}Ti_{0.9625}O_3\}+0.08MnO_2$) having a thickness of 1.5 $\mu$m, and the second electrode layer is an Au film having a thickness of 0.2 $\mu$m.

A target obtained by mixing together Ru powder and Ba powder and press-forming the mixture was sputtered by a sputtering apparatus for 10 minutes while heating the substrate to 500°C and applying a high-frequency power of 100 W to the target in an argon atmosphere at 0.5 Pa, to obtain the first electrode layer.

The first electrode layer was an Ru film preferentially oriented along the (111) plane and containing 1.0 mol% of Ba.

A sinter target of PLT (with addition of 15 mol% of La) and an Mn target were sputtered by a multi-target sputtering apparatus for 4 hours while heating the substrate to 550°C and applying a high-frequency power of 200 W to the PLT target and 50 W to the Mn target for a simultaneous discharge in a mixed atmosphere of argon and oxygen (gas volume ratio: $Ar:O_2=18:2$) at a degree of vacuum of 1.0 Pa, to obtain the pyroelectric layer.

The chemical composition and the crystalline structure of the pyroelectric layer were examined as in Example 6 before the formation of the second electrode layer.

The chemical composition of the pyroelectric layer was represented as:

$$(1-z)\{(Pb_{(1-y)}La_y)Ti_{(1-y/4)}O_3\}+zAOn$$

where z=0.08, y=0.15, A=Mn and n=2.

The crystalline structure was a tetragonal perovskite crystalline structure with the degree $\alpha$ of (001) orientation being 95%.

An Au pellet was irradiated with an electron beam onto the pyroelectric layer by a vacuum evaporation method using a vacuum evaporation apparatus with the substrate being at room temperature in a vacuum of $5 \times 10^{-4}$ Pa, to obtain the second electrode layer.

COMPARATIVE EXAMPLE 13

In Comparative Example 13, a pyroelectric device having the same structure as that of Example 9 was produced except that the first electrode layer was made only of Ru containing no Ba.

The pyroelectric layer of this comparative example was preferentially oriented along the (111) plane, with the degree $\alpha$ of (001) orientation being 10% or less, and the thickness thereof was 1.6 $\mu$m.

The pyroelectric characteristics of Example 9 and Comparative Example 13 are shown in FIG. **13.**

As can be seen from FIG. **13,** Example 9 has a pyroelectric coefficient 11 times that of Comparative Example 13, a relative dielectric constant about 1/3 that of Comparative Example 13, a dielectric loss about 1/7 that of Comparative Example 13 and a pyroelectric coefficient/relative dielectric constant about 32 times that of Comparative Example 12. Thus, it is clear that Example 9 has superior characteristics as a pyroelectric device.

Moreover, 100 pyroelectric devices of Example 9 and 100 pyroelectric devices of Comparative Example 13 were produced, and it was indicated that the yield for devices having a pyroelectric coefficient of 0.7 (the average value for Comparative Example 13) or more was 100% for Example 9 and 50% for Comparative Example 13. The pyroelectric coefficient variation σ with respect to the value shown in FIG. **13** was $0.3\times10^{-8}$ for Example 9 and $0.4\times10^{-8}$ for Comparative Example 13, indicating that Example 9 had a smaller pyroelectric characteristics variation, a smaller number of production steps and an improved mass-production yield, as compared with Comparative Example 13.

EXAMPLE 10

An Ir alloy target containing 5 mol% of Ti was sputtered for 15 minutes onto a silicon substrate having a thickness of 0.3 mm, an average thermal expansion coefficient of $25 \times 10^{-7}/°C$ and a diameter of 4 inches while heating the substrate to 400°C and applying a high-frequency power of 200 W thereto in an argon gas at 1 Pa, to obtain a first electrode layer having a thickness of 0.20 μm.

An analysis of the first electrode layer with an X-ray diffraction method showed that the (200) plane and the (111) plane coexisted in the film, and an analysis with an X-ray photoelectron spectroscopy (XPS) showed that the Ti content was the same as that of the alloy target, i.e., 5.0 mol%.

Then, a sinter target of ($Pb_{0.90}La_{0.10}Zr_{0.53625}Ti_{0.43875}O_3$) was sputtered for 3 hours onto the first electrode layer while heating the substrate to 550°C and applying a high-frequency power of 250 W thereto in a mixed atmosphere of argon and oxygen (gas volume ratio: $Ar:O_2=19:1$) at a degree of vacuum of 0.3 Pa, to obtain a pyroelectric layer having a thickness of 3.0 μm.

The pyroelectric layer grew with Ti atoms interspersed across the surface of the first electrode layer as nuclei, and was oriented along the (001) plane. During the formation of the pyroelectric layer, Ti formed $TiO_2$ whose height as exposed on the surface of the first electrode layer was 0.002 μm or less, and the pyroelectric layer grew while being oriented along the (100) plane.

While the pyroelectric layer is oriented along the (110) plane in areas where Ti is not present, the thickness thereof is 0.02 μm or less. By setting the thickness of the pyroelectric layer to 3.0 μm, it was possible to form a pyroelectric layer with desirable crystallinity and orientation in a single production step.

An analysis of the composition of the pyroelectric layer in the present example with an X-ray microanalyzer showed that the La content was the same as that of the target, i.e., 10 mol%, and the Zr:Ti ratio was the same as that of the target, i.e., 55:45 mol%, confirming that the composition of the pyroelectric layer was substantially the same as that of the target.

Thus, the composition is represented as:

$$(Pb_{(1-y)}La_y)(Zr_xTi_{(1-x)})_{(1-y/4)}O_3$$

where x=0.55 and y=0.10.

An analysis of the crystalline structure of the pyroelectric layer with an X-ray diffraction method showed that it was a rhombohedral perovskite crystalline structure oriented along the (100) plane with the degree α of orientation being 100%.

Herein, the degree of (100) orientation ("α(100)") is defined as $\alpha(100)=I(100)/\Sigma I(hkl)$. I(100) is the diffraction peak intensity for a Cu-Kα 2θ value around 22° in an X-ray diffraction method, and ΣI(hkl) is the sum of diffraction peak intensities from various crystal faces for a Cu-Kα 2θ range of 10° to 70° in an X-ray diffraction method.

Note that the (200) plane and the (002) plane are not included in ΣI(hkl) as they are equivalent to the (100) plane and the (001) plane.

The average thermal expansion coefficient of the substrate in the present example is 43% of that of the pyroelectric layer, thus giving a tensile stress upon the pyroelectric layer and promoting the preferential orientation along the rhombohedral (100) plane.

Finally, an Ni-Cr second electrode layer having a thickness of 0.2 μm was formed on the pyroelectric layer by a sputtering method.

An infrared radiation sensor as shown in FIG. **3** was produced by using a pyroelectric device as described above. First, a polyimide insulating film is formed so that a portion of the second electrode layer of the pyroelectric device is exposed, and a lead electrode extending from the second electrode layer is formed. Then, a portion of the silicon substrate below the pyroelectric device is etched away, and a lead electrode extending from the first electrode layer is formed. Thus, two output terminals for outputting an electric signal from the pyroelectric device are formed.

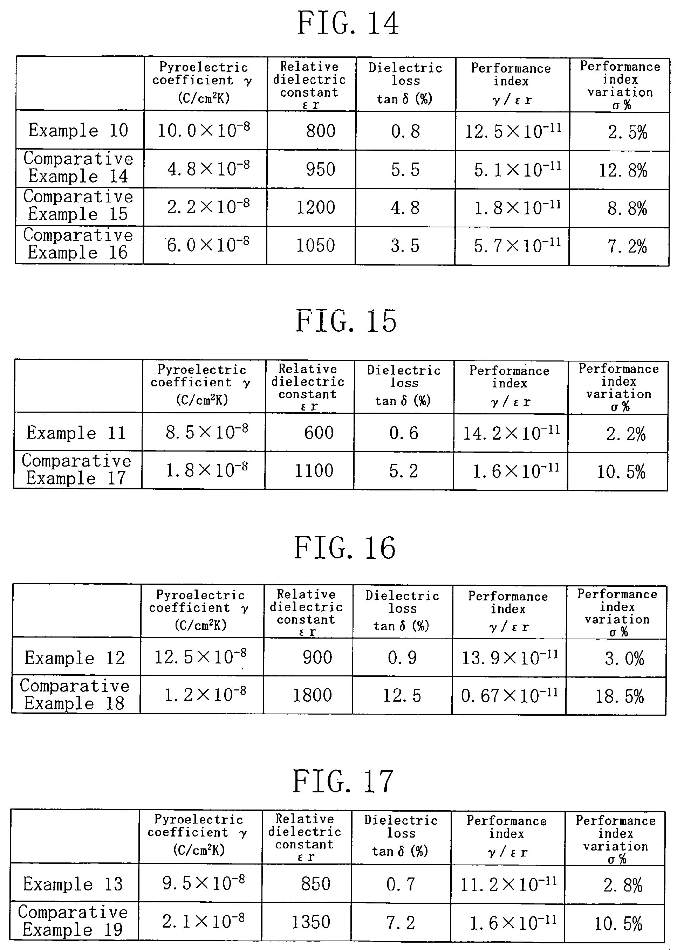

The pyroelectric device is irradiated with infrared rays coming from the outside to change the temperature of the pyroelectric device, and the polarization of the pyroelectric layer is changed by the temperature change. The generated electric charge is taken out through the output terminals. The performance of the device as an infrared radiation sensor was evaluated in this way. Specifically, the temperature of the infrared radiation sensor itself was changed, and the pyroelectric current flowing at that time was measured by a pA meter through the output terminals, and the pyroelectric coefficient was calculated. Moreover, the relative dielectric constant εr of the pyroelectric layer was calculated based on the measurement of an electric capacity between the first electrode layer and the second electrode layer using an LCR meter under a 1 kHz and 1 V condition. The dielectric loss tanδ was measured by an LCR meter under a similar condition. The pyroelectric characteristics are shown in FIG. **14.**

The pyroelectric characteristics of Comparative Examples 14 to 16 to be described below are also shown in FIG. **14.**

COMPARATIVE EXAMPLE 14

In Comparative Example 14, a pyroelectric device having the same structure as that of Example 10 was produced except that Ir was used for the first electrode layer and a (100)-oriented MgO intermediate layer having a thickness of 0.2 μm was formed on the first electrode layer by an MOCVD method according to Japanese Patent Application Laid Open Publication No. 7-300397.

The pyroelectric layer of this comparative example had a rhombohedral perovskite crystalline structure oriented along the (100) plane, with the degree α of orientation being 75%.

An infrared radiation sensor of Comparative Example 14 was produced as in Example 10, and the pyroelectric characteristics thereof were evaluated. Herein, a larger pyroelectric coefficient, a smaller relative dielectric constant, a smaller dielectric loss and a larger figure of merit each indicate a better infrared radiation sensor characteristic.

As can be seen from FIG. **14,** Example 10 has a pyroelectric coefficient about 2.1 times that of Comparative Example 14, a relative dielectric constant 0.84 times that of Comparative Example 14, a dielectric loss 0.15 times that of Comparative Example 14 and a pyroelectric coefficient/relative dielectric constant (the figure of merit of the pyroelectric device) about 2.5 times that of Comparative Example 14. Thus, Example 10 is superior to Comparative Example 14 in every parameter and it is clear that Example 10 has superior characteristics as an infrared radiation sensor.

Furthermore, 100 infrared radiation sensors of Example 10 and 100 infrared radiation sensors of Comparative Example 14 were produced and compared with each other in the figure of merit variation value σ%, which represents the sensor characteristics variation. As a result, the σ% value was 2.5% for Example 10 and 12.8% for Comparative Example 14, indicating that Example 10 had a smaller characteristics variation, a smaller number of production steps and an improved mass-production yield, as compared with Comparative Example 14.

COMPARATIVE EXAMPLE 15

In Comparative Example 15, a pyroelectric device having the same structure as that of Example 10 was produced except that the first electrode layer was made only of Ir containing no Ti.

The pyroelectric layer of this comparative example was preferentially oriented along the (110) plane, with the degree α of (100) orientation being 5% or less. Referring to FIG. **14,** the pyroelectric coefficient was 0.22 times that of Example 10, the relative dielectric constant was about 1.5 times that of Example 10, the dielectric loss was 6 times that of Example 10 and the figure of merit was about 0.14 times that of Example 10. Thus, it is clear that Example 10 has better pyroelectric characteristics as a pyroelectric device than Comparative Example 15.

Furthermore, 100 infrared radiation sensors of Example 10 and 100 infrared radiation sensors of Comparative Example 15 were produced and compared with each other in the figure of merit variation value σ%, which represents the sensor characteristics variation. As a result, the σ% value was 2.5% for Example 10 and 8.8% for Comparative Example 15, indicating that Example 10 had a smaller characteristics variation and an improved mass-production yield, as compared with Comparative Example 15.

COMPARATIVE EXAMPLE 16

In Comparative Example 16, a (111)-oriented Pt electrode having a thickness of 100 nm was formed on the silicon substrate of Example 10, and a PLZT pyroelectric thin film having the same composition as that of Example 10 was formed thereon according to Japanese Patent Application Laid Open Publication No. 7-307496. As a result, although the obtained PLZT thin film was preferentially oriented along the (111) plane, other crystal planes, i.e., the (100) plane and the (110) plane, also existed, with the degree of (111) orientation being only 75%, and the peak intensity of the (111) plane was about 1/10 that of the (100) plane of Example 10.

As can be seen from FIG. **14,** Example 10 has a pyroelectric coefficient 1.67 times that of Comparative Example 16, a relative dielectric constant 0.76 times that of Comparative Example 16, a dielectric loss 0.23 times that of Comparative Example 16 and a figure of merit about 2.2 times that of Comparative Example 16. Thus, Example 10 is superior to Comparative Example 16 in every parameter and it is clear that Example 10 has superior characteristics as a pyroelectric device.

Thus, in the structure of Japanese Patent Application Laid Open Publication No. 7-307496, the degree of (111) orientation of the pyroelectric material is not 100%. Therefore, the performance thereof as a pyroelectric device was poor as compared with the pyroelectric device of the present example.

Furthermore, 100 infrared radiation sensors of Example 10 and 100 infrared radiation sensors of Comparative Example 16 were produced and compared with each other in the figure of merit variation value σ%, which represents the sensor characteristics variation. As a result, the σ% value was 2.5% for Example 10 and 7.2% for Comparative Example 16, indicating that Example 10 had a smaller characteristics variation and an improved mass-production yield, as compared with Comparative Example 16.

EXAMPLE 11

A Pyrex glass substrate having a thickness of 0.5 mm and a size of 20 mm by 20 mm was used in the present example. The average thermal expansion coefficient of this substrate is $32 \times 10^{-7}/°C$, 53% of that of the pyroelectric layer.

In this example, the first electrode layer is a Pt film having a thickness of 0.25 μm and containing 2 mol% of Co, the pyroelectric layer is a PZT thin film ($PbZr_{0.60}Ti_{0.40}O_3$) having a thickness of 2.5 μm, and the second electrode layer is a Pt film having a thickness of 0.1 μm.

The composition of the pyroelectric layer is represented as:

$$(Pb_{(1-y)}La_y)(Zr_xTi_{(1-x)})_{(1-y/4)}O_3$$

where x=0.60 and y=0.

The pyroelectric layer of the present example was preferentially oriented along the (100) plane, with the degree α of orientation being 95%.

A Pt target and a Co target were sputtered by a multi-target sputtering apparatus for 20 minutes while heating the substrate to 400°C and applying a high-frequency power of 100 W to the Pt target and 50 W to the Co target for a simultaneous discharge in a mixed atmosphere of argon and oxygen (gas volume ratio: $Ar:O_2$=19:1) at 1 Pa, to obtain the first electrode layer.

An analysis on the chemical composition and the crystalline structure of the first electrode layer, before the formation of the pyroelectric layer, showed that the electrode thin film showed a (111) plane and a (200) plane and contained 1.9 mol% of Co.

A sinter target of PZT (Zr/Ti ratio=55/45 mol%) was sputtered for 3 hours while heating the substrate to 600°C and applying a high-frequency power of 250 W thereto in a mixed atmosphere of argon and oxygen (gas volume ratio: $Ar:O_2$=19:1) at a degree of vacuum of 0.3 Pa, to obtain the pyroelectric layer.

A Pt pellet was irradiated with an electron beam to be evaporated onto the pyroelectric layer using a vacuum evaporation apparatus in a vacuum of $5 \times 10^{-4}$ Pa with the substrate being at room temperature, to obtain the second electrode layer.

The chemical composition and the crystalline structure of the pyroelectric layer were examined as in Example 10 before the formation of the second electrode layer, indicating that the chemical composition was substantially the same as that of the target and the crystalline structure was a rhombohedral perovskite crystalline structure with the degree α of (100) orientation being 98%.

COMPARATIVE EXAMPLE 17

In Comparative Example 17, a pyroelectric device having the same structure as that of Example 11 was produced except that the first electrode layer was made only of Pt containing no Co.

The pyroelectric layer of this comparative example was randomly oriented, with the degree of (100) orientation being 15% or less.

Infrared sensors were produced as in Example 10, using pyroelectric devices of Example 11 and Comparative Example 17 as described above. The infrared radiation sensors were evaluated for their performance. The results are shown in FIG. **15.**

As can be seen from FIG. **15,** Example 11 has a pyroelectric coefficient about 4.7 times that of Comparative Example 17, a relative dielectric constant 0.55 times that of Comparative Example 17, a dielectric loss 0.11 times that of Comparative Example 17 and a figure of merit about 8.9 times that of Comparative Example 17. Thus, it is clear that Example 11 has superior characteristics as an infrared radiation sensor to Comparative Example 17.

Furthermore, 100 infrared radiation sensors of Example 11 and 100 infrared radiation sensors of Comparative Example 17 were produced and compared with each other in the figure of merit variation value σ%, which represents the sensor characteristics variation. As a result, the σ% value was 2.2% for Example 11 and 10.5% for Comparative Example 17, indicating that Example 11 had a smaller characteristics variation and an improved mass-production yield, as compared with Comparative Example 17.

EXAMPLE 12

A silicon substrate having a thickness of 0.5 mm was used in the present example. The average thermal expansion coefficient of this substrate is $26 \times 10^{-7}/°C$, 43% of that of the pyroelectric layer.

In the present example, the first electrode layer is a Pd film having a thickness of 0.3 μm and containing 15 mol% of Al, the pyroelectric layer is an MgO-added PLZT thin film having a thickness of 3.5 μm and represented as:

$$0.9(Pb_{0.80}La_{0.20}Zr_{0.665}Ti_{0.285}O_3)+0.1MgO,$$

and the second electrode layer is a Cu film having a thickness of 0.05 μm.

A pellet obtained by mixing together Pd and Al at 9:1 was irradiated with an electron beam to simultaneously evaporate Pd and Al onto the substrate by a vacuum evaporation method using a vacuum evaporation apparatus while heating the substrate to 400°C in a vacuum of $5 \times 10^{-4}$ Pa, to obtain the first electrode layer.

The first electrode layer was amorphous Pd containing 15 mol% of Al.

An MgO-added PLZT sinter target was sputtered for 3 hours while heating the substrate to 650°C and applying a high-frequency power of 250 W thereto in a mixed atmosphere of argon and oxygen (gas volume ratio: $Ar:O_2=19.5:0.5$) at a degree of vacuum of 0.2 Pa, to obtain the pyroelectric layer.

The chemical composition and the crystalline structure of the pyroelectric layer were examined as in Example 10 before the formation of the second electrode layer.

The chemical composition of the pyroelectric layer was the same as that of the target, and was represented as:

$$(1\text{-}z)\{(Pb_{(1-y)}La_y)(Zr_xTi_{(1-x)})_{(1-y/4)}O_3\}+zAO_n$$

where x=0.70, y=0.20 and z=0.1.

The crystalline structure of the pyroelectric layer was a rhombohedral perovskite crystalline structure with the degree a of (100) orientation being 95%.

A Cu pellet was irradiated with an electron beam to be evaporated onto the pyroelectric layer using a vacuum evaporation apparatus in a vacuum of $5 \times 10^{-4}$ Pa with the substrate being at room temperature, to obtain the second electrode layer.

COMPARATIVE EXAMPLE 18

In Comparative Example 18, a pyroelectric device having the same structure as that of Example 12 was produced except that the first electrode layer was made only of Pd containing 25 mol% of Al.

The pyroelectric layer of this comparative example was a film in which a randomly-oriented perovskite crystalline structure with low peak intensities and a peak of lead oxide coexisted, and the degree α of (100) orientation calculated from all the peaks was 3% or less.

Infrared sensors were produced as in Example 10, using pyroelectric devices of Example 12 and Comparative Example 18 as described above. The infrared radiation sensors were evaluated for their performance. The results are shown in FIG. **16.**

As can be seen from FIG. **16,** Example 12 has a pyroelectric coefficient 10 times that of Comparative Example 18, a relative dielectric constant 0.5 times that of Comparative Example 18, a dielectric loss about 0.072 times that of Comparative Example 18 and a figure of merit about 21 times that of Comparative Example 18. Thus, it is clear that Example 12 has superior characteristics as a pyroelectric device to Comparative Example 18.

Furthermore, 100 infrared radiation sensors of Example 12 and 100 infrared radiation sensors of Comparative Example 18 were produced and compared with each other in the figure of merit variation value σ%, which represents the sensor characteristics variation. As a result, the σ% value was 3.0 for Example 12 and 18.5% for Comparative Example 18, indicating that Example 12 had a smaller characteristics variation and an improved mass-production yield, as compared with Comparative Example 18.

EXAMPLE 13

A Pyrex glass substrate having a thickness of 1.0 mm was used in the present example. The average thermal expansion coefficient of this substrate is $32 \times 10^{-7}/^\circ C$, 53% of that of the pyroelectric layer.

In this example, the first electrode layer is an Ru film having a thickness of 0.4 $\mu$m and containing 1 mol% of Sr, the pyroelectric layer is an $MnO_2$-added PZT film having a thickness of 1.5 $\mu$m and represented as:

$$0.98(PbZr_{0.55}Ti_{0.45}O_3)+0.02MnO_2,$$

and the second electrode layer is an Au film having a thickness of 0.2 $\mu$m.

A target obtained by mixing together Ru powder and Sr powder and press-forming the mixture was sputtered by a sputtering apparatus for 10 minutes while heating the substrate to 500$^\circ$C and applying a high-frequency power of 100 W to the target in an argon atmosphere at 0.5 Pa, to obtain the first electrode layer.

The first electrode layer was an amorphous Ru film containing 1.0 mol% of Sr.

A sinter target of PZT (Zr/Ti ratio=55/45 mol%) and an Mn target were sputtered by a multi-target sputtering apparatus for 4 hours while heating the substrate to 550$^\circ$C and applying a high-frequency power of 200 W to the PZT target and 50 W to the Mn target for a simultaneous discharge in a mixed atmosphere of argon and oxygen (gas volume ratio: Ar:$O_2$=18:2) at 1.0 Pa, to obtain the pyroelectric layer.

The chemical composition and the crystalline structure of the pyroelectric layer were examined as in Example 10 before the formation of the second electrode layer.

The chemical composition of the pyroelectric layer was:

$$(1-z)\{(Pb_{(1-y)}La_y)(Zr_xTi_{(1-x)})_{(1-y/4)}O_3\}+zAO_n$$

where x=0.55, y=0, z=0.02, A=Mn and n=2.

The crystalline structure was a rhombohedral perovskite crystalline structure with the degree $\alpha$ of (100) orientation being 96%.

An Au pellet was irradiated with an electron beam onto the pyroelectric layer by a vacuum evaporation method using a vacuum evaporation apparatus with the substrate being at room temperature in a vacuum of $5 \times 10^{-4}$ Pa, to obtain the second electrode layer.

COMPARATIVE EXAMPLE 19

In Comparative Example 19, a pyroelectric device having the same structure as that of Example 13 was produced except that the first electrode layer was made only of Ru containing no Sr.

The pyroelectric layer of this comparative example was randomly oriented, with the degree of (001) orientation being 30% or less.

Infrared sensors were produced as in Example 10, using pyroelectric devices of Example 13 and Comparative Example 19 as described above. The infrared radiation sensors were evaluated for their performance. The results are shown in FIG. 17.

As can be seen from FIG. 17, Example 13 has a pyroelectric coefficient 4.5 times that of Comparative Example 19, a relative dielectric constant 0.63 times that of Comparative Example 19, a dielectric loss 0.097 times that of Comparative Example 19 and a figure of merit about 7.2 times that of Comparative Example 19. Thus, it is clear that Example 13 has superior characteristics as a pyroelectric device to Comparative Example 19.

Furthermore, 100 infrared radiation sensors of Example 13 and 100 infrared radiation sensors of Comparative Example 19 were produced and compared with each other in the figure of merit variation value $\sigma$%, which represents the sensor characteristics variation. As a result, the $\sigma$% value was 2.8% for Example 13 and 10.5% for Comparative Example 19, indicating that Example 13 had a smaller characteristics variation and an improved mass-production yield, as compared with Comparative Example 19.

Note that in the examples described above, the pyroelectric layer is a PLT thin film of $(Pb_{0.90}La_{0.10}Ti_{0.975}O_3)$, a PLMT thin film of $(0.96\{Pb_{0.95}La_{0.05}Ti_{0.9875}O_3\}+0.04MgO)$ or $(0.92\{Pb_{0.85}La_{0.15}Ti_{0.9625}O_3\}+0.08MnO_2)$, a PLZT thin film of $(Pb_{0.95}La_{0.05}Zr_{0.09875}Ti_{0.88875}O_3)$ or $(0.9\{(Pb_{0.8}La_{0.2})(Zr_{0.19}Ti_{0.76})O_3\}+0.1MgO)$, a PLZT thin film of $(Pb_{0.90}La_{0.10}Zr_{0.53625}Ti_{0.43875}O_3)$, a PZT thin film of $(PbZr_{0.60}Ti_{0.40}O_3)$, an MgO-added PLZT thin film of $\{0.9(Pb_{0.80}La_{0.20}Zr_{0.665}Ti_{0.285}O_3)+0.1MgO\}$, or an $MnO_2$-added PZT thin film $\{0.98(PbZr_{0.55}Ti_{0.45}O_3)+0.02MnO_2\}$. However, the present invention is not limited to these compositions, but desirable pyroelectric characteristics and infrared radiation sensor characteristics were obtained as in the examples described above as long as the composition was

represented as:

$$(Pb_{(1-y)}La_y)Ti_{(1-y/4)}O_3$$

(where $0 < y \leq 0.2$)

or

$$(Pb_{(1-y)}La_y)(Zr_xTi_{(1-x)})_{(1-y/4)}O_3$$

(where $0 < x \leq 0.2$ or $0.55 \leq x < 0.8$ and $0 \leq y \leq 0.2$),

or as:

$$(1-z)\{(Pb_{(1-y)}La_y)Ti_{(1-y/4)}O_3\}+zAOn$$

(where $0 < y \leq 0.2$, $0 < z \leq 0.1$, and A is Mg or Mn, wherein n=1 if A is Mg, and n=2 if A is Mn) or

$$(1-z)\{(Pb_{(1-y)}La_y)(Zr_xTi_{(1-x)})_{(1-y/4)}O_3\}+zAO_n$$

(where $0 < x \leq 0.2$ or $0.55 \leq x < 0.8$, $0 \leq y \leq 0.2$, $0 < z \leq 0.1$, and A is Mg or Mn, wherein n=1 if A is Mg, and n=2 if A is Mn).

Furthermore, in the examples described above, the material of the first electrode layer of the pyroelectric device is Pt containing 2.2 mol% of Al, Ir containing 5 mol% of Al, Pd containing 8 mol% of Al, Ru containing 1 mol% of $Al_2O_3$, Pt containing 18 mol% of Al, Ir containing 5 mol% of Ti, Pt containing 2 mol% of Co, Pd containing 15 mol% of Al, or Ru containing 1.0 mol% of Sr. However, the present invention is not limited to these compositions, but desirable pyroelectric characteristics and infrared radiation sensor characteristics were obtained as in the examples described above as long as it was a noble metal containing at least one additive selected from the group consisting of Ti, Co, Ni, Mg, Fe, Ca, Sr, Mn, Ba and Al and oxides thereof.

Note that where the pyroelectric material is a rhombohedral perovskite crystal, the same pyroelectric characteristics as those obtained when the thermal expansion coefficient of the substrate is smaller than that of the pyroelectric thin film can be obtained even when the thermal expansion coefficient of the substrate is larger than that of the pyroelectric thin film. This is because a rhombohedral perovskite crystal has its polarization axis perpendicular to the (111) plane, whereby the polarization axis will be inclined by about 57° with respect to the substrate whether the pyroelectric thin film is oriented along the (100) plane or along the (001) plane.

Thus, the following effects are obtained according to the embodiment described above.

(1) By forming a first electrode layer made of a noble metal containing at least one additive selected from the group consisting of Ti, Co, Ni, Mg, Fe, Ca, Sr, Mn, Ba and Al and oxides thereof, a pyroelectric layer having a perovskite crystalline structure whose chemical composition is represented as:

$$(Pb_{(1-y)}La_y)Ti_{(1-y/4)}O_3$$

(where $0 < y \leq 0.2$)

or

$$(Pb_{(1-y)}La_y)(Zr_xTi_{(1-x)})_{(1-y/4)}O_3$$

(where $0<x\leq0.2$ or $0.55\leq x<0.8$ and $0<y\leq0.2$),

and a second electrode layer in this order on a substrate, it is possible to obtain a pyroelectric device with desirable pyroelectric characteristics in which the pyroelectric layer has desirable crystallinity and orientation.

(2) By forming a first electrode layer made of a noble metal containing at least one additive selected from the group consisting of Ti, Co, Ni, Mg, Fe, Ca, Sr, Mn, Ba and Al and oxides thereof on a substrate, then forming a pyroelectric layer having a thickness of 0.5 to 5 μm and having a perovskite crystalline structure whose chemical composition is represented as:

$$(Pb_{(1-y)}La_y)Ti_{(1-y/4)}O_3$$

(where $0<y\leq0.2$)

or

$$(Pb_{(1-y)}La_y)(Zr_xTi_{(1-x)})_{(1-y/4)}O_3$$

(where $0<x\leq0.2$ or $0.55\leq x<0.8$ and $0<y\leq0.2$),

and finally forming a second electrode layer, it is possible to provide a manufacturing method capable of producing a pyroelectric device with desirable pyroelectric characteristics in which the pyroelectric layer has desirable crystallinity and orientation with a small number of production steps, with a small pyroelectric characteristics variation, and with a desirable mass-production yield.

(3) By connecting output terminals to a pyroelectric device obtained by forming a first electrode layer made of a noble metal containing at least one additive selected from the group consisting of Ti, Co, Ni, Mg, Fe, Ca, Sr, Mn, Ba and Al and oxides thereof, a pyroelectric layer having a thickness of 0.5 to 5 μm and having a perovskite crystalline structure whose chemical composition is represented as:

$$(Pb_{(1-y)}La_y)Ti_{(1-y/4)}O_3$$

(where $0<y\leq0.2$)

or

$$(Pb_{(1-y)}La_y)(Zr_xTi_{(1-x)})_{(1-y/4)}O_3$$

(where $0<x\leq0.2$ or $0.55\leq x<0.8$ and $0<y\leq0.2$),

and a second electrode layer in this order on a substrate, it is possible to provide an inexpensive infrared radiation sensor having desirable pyroelectric characteristics.

INDUSTRIAL APPLICABILITY

The pyroelectric device and the infrared radiation sensor of the present invention are useful in small-sized, high-sensitivity infrared detectors for detecting the temperature of an object in a noncontact manner and at a high speed to be used in fields of application including electric home appliances, security appliances, FA, HA, car electronics, etc., or in other types of infrared detectors. The present invention having desirable pyroelectric characteristics and being inexpensive has a high industrial applicability.

**Claims**

1. A pyroelectric device, comprising:

   a first electrode layer;
   a pyroelectric layer provided on the first electrode layer; and
   a second electrode layer provided on the pyroelectric layer, wherein:

      the first electrode layer includes a noble metal containing at least one additive selected from the group consisting of Ti, Co, Ni, Mg, Fe, Ca, Sr, Mn, Ba and Al and oxides thereof; and
      the pyroelectric layer includes a pyroelectric material having a perovskite crystalline structure whose composition is represented as:

$$(Pb_{(1-y)}La_y)Ti_{(1-y/4)}O_3$$

$$(\text{where } 0 < y \leq 0.2)$$

   or

$$(Pb_{(1-y)}La_y)(Zr_xTi_{(1-x)})_{(1-y/4)}O_3$$

$$(\text{where } 0 < x \leq 0.2 \text{ or } 0.55 \leq x < 0.8 \text{ and } 0 < y \leq 0.2).$$

2. The pyroelectric device of claim 1, wherein the pyroelectric layer further includes AOn (A is Mg or Mn, wherein n=1 if A is Mg, and n=2 if A is Mn) at a composition represented as:

$$(1-z)\{(Pb_{(1-y)}La_y)Ti_{(1-y/4)}O_3\}+zAon$$

$$(\text{where } 0 < y \leq 0.2 \text{ and } 0 < z \leq 0.1)$$

   or

$$(1-z)\{(Pb_{(1-y)}La_y)(Zr_xTi_{(1-x)})_{(1-y/4)}O_3\}+zAOn$$

$$(\text{where } 0 < x \leq 0.2 \text{ or } 0.55 \leq x < 0.8, 0 < y \leq 0.2 \text{ and } 0 < z \leq 0.1).$$

3. The pyroelectric device of claim 1 or 2, wherein the pyroelectric layer has a thickness of $0.5\,\mu m$ to $5\,\mu m$.

4. The pyroelectric device of claim 1 or 2, wherein the first electrode layer includes at least one noble metal selected from the group consisting of Pt, Ir, Pd and Ru and at least one additive selected from the group consisting of Ti, Co, Ni, Mg, Fe, Ca, Sr, Mn, Ba and Al and oxides thereof.

5. The pyroelectric device of claim 1 or 2, wherein a content of the at least one additive selected from the group consisting of Ti, Co, Ni, Mg, Fe, Ca, Sr, Mn, Ba and Al and oxides thereof in the first electrode layer is greater than 0 and less than or equal to 20 mol% with respect to that of the noble metal.

6. The pyroelectric device of claim 1 or 2, wherein:

   the first electrode layer is provided on a substrate; and
   the substrate has an average thermal expansion coefficient 110% to 300% of that of the pyroelectric layer.

7. The pyroelectric device of claim 1 or 2, wherein:

the first electrode layer is provided on a substrate; and
the substrate has an average thermal expansion coefficient 20% to 100% of that of the pyroelectric layer.

8. A method for manufacturing a pyroelectric device, comprising:

a first step of forming a first electrode layer made of a noble metal containing at least one additive selected from the group consisting of Ti, Co, Ni, Mg, Fe, Ca, Sr, Mn, Ba and Al and oxides thereof on a substrate;
a second step of forming, on the first electrode layer, a pyroelectric layer having a thickness of 0.5 μm to 5 μm and including a pyroelectric material having a perovskite crystalline structure whose composition is represented as:

$$(Pb_{(1-y)}La_y)Ti_{(1-y/4)}O_3$$

(where $0<y\leq0.2$)

or

$$(Pb_{(1-y)}La_y)(Zr_xTi_{(1-x)})_{(1-y/4)}O_3$$

(where $0<x\leq0.2$ or $0.55\leq x<0.8$ and $0<y\leq0.2$); and

a third step of forming a second electrode layer on the pyroelectric layer.

9. The method for manufacturing a pyroelectric device of claim 8, wherein the pyroelectric layer further includes AOn (A is Mg or Mn, wherein n=1 if A is Mg, and n=2 if A is Mn) at a composition represented as:

$$(1-z)\{(Pb_{(1-y)}La_y)Ti_{(1-y/4)}O_3\}+zAOn$$

(where $0<y\leq0.2$ and $0<z\leq0.1$)

or

$$(1-z)\{(Pb_{(1-y)}La_y)(Zr_xTi_{(1-x)})_{(1-y/4)}O_3\}+zAOn$$

(where $0<x\leq0.2$ or $0.55\leq x<0.8$, $0<y\leq0.2$ and $0<z\leq0.1$).

10. The method for manufacturing a pyroelectric device of claim 8 or 9, wherein the second step is performed by a sputtering method.

11. An infrared radiation sensor, comprising:

a pyroelectric device; and
an output terminal for outputting an electric signal from the pyroelectric device, wherein:

the pyroelectric device includes a first electrode layer, a pyroelectric layer provided on the first electrode layer, and a second electrode layer provided on the pyroelectric layer;
the first electrode layer includes a noble metal containing at least one additive selected from the group consisting of Ti, Co, Ni, Mg, Fe, Ca, Sr, Mn, Ba and Al and oxides thereof; and

the pyroelectric layer has a thickness of 0.5 µm to 5 µm and includes a pyroelectric material having a perovskite crystalline structure whose composition is represented as:

$$(Pb_{(1-y)}La_y)Ti_{(1-y/4)}O_3$$

(where $0<y\leq0.2$)

or

$$(Pb_{(1-y)}La_y)(Zr_xTi_{(1-x)})_{(1-y/4)}O_3$$

(where $0<x\leq0.2$ or $0.55\leq x<0.8$ and $0<y\leq0.2$).

12. The infrared radiation sensor of claim 11, wherein the pyroelectric layer further includes AOn (A is Mg or Mn, wherein n=1 if A is Mg, and n=2 if A is Mn) at a composition represented as:

$$(1-z)\{(Pb_{(1-y)}La_y)Ti_{(1-y/4)}O_3\}+zAOn$$

(where $0<y\leq0.2$ and $0<z\leq0.1$)

or

$$(1-z)\{(Pb_{(1-y)}La_y)(Zr_xTi_{(1-x)})_{(1-y/4)}O_3\}+zAOn$$

(where $0<x\leq0.2$ or $0.55\leq x<0.8$, $0<y\leq0.2$ and $0<z\leq0.1$).

# FIG. 1

# FIG. 2

| Formation of first electrode layer | ∿ S1 |

| Formation of pyroelectric layer | ∿ S2 |

| Formation of second electrode layer | ∿ S3 |

FIG. 3

FIG. 4

## FIG. 5

| | Pyroelectric coefficient $\gamma$ (C/cm$^2$K) | Relative dielectric constant $\varepsilon$ r | Dielectric loss tan $\delta$ (%) | Performance index $\gamma / \varepsilon$ r |
|---|---|---|---|---|
| Example 1 | $10.0 \times 10^{-8}$ | 160 | 0.7 | $6.25 \times 10^{-10}$ |
| Comparative Example 1 | $5.0 \times 10^{-8}$ | 220 | 1.5 | $2.3 \times 10^{-10}$ |
| Comparative Example 2 | $1.2 \times 10^{-8}$ | 400 | 3.0 | $0.3 \times 10^{-10}$ |
| Comparative Example 3 | $4.0 \times 10^{-8}$ | 380 | 2.0 | $1.1 \times 10^{-10}$ |

## FIG. 6

| | Pyroelectric coefficient $\gamma$ (C/cm$^2$K) | Relative dielectric constant $\varepsilon$ r | Dielectric loss tan $\delta$ (%) | Performance index $\gamma / \varepsilon$ r |
|---|---|---|---|---|
| Example 2 | $11.0 \times 10^{-8}$ | 160 | 0.8 | $6.88 \times 10^{-10}$ |
| Comparative Example 4 | $0.9 \times 10^{-8}$ | 550 | 3.5 | $0.2 \times 10^{-10}$ |

## FIG. 7

| | Pyroelectric coefficient $\gamma$ (C/cm$^2$K) | Relative dielectric constant $\varepsilon$ r | Dielectric loss tan $\delta$ (%) | Performance index $\gamma / \varepsilon$ r |
|---|---|---|---|---|
| Example 3 | $11.5 \times 10^{-8}$ | 210 | 0.7 | $5.5 \times 10^{-10}$ |
| Comparative Example 5 | $2.0 \times 10^{-8}$ | 800 | 3.8 | $0.3 \times 10^{-10}$ |

## FIG. 8

| | Pyroelectric coefficient $\gamma$ (C/cm$^2$K) | Relative dielectric constant $\varepsilon r$ | Dielectric loss tan $\delta$ (%) | Performance index $\gamma / \varepsilon r$ |
|---|---|---|---|---|
| Example 4 | $9.5 \times 10^{-8}$ | 170 | 0.5 | $5.5 \times 10^{-10}$ |
| Comparative Example 6 | $0.7 \times 10^{-8}$ | 450 | 4.5 | $0.2 \times 10^{-10}$ |

## FIG. 9

| | Pyroelectric coefficient $\gamma$ (C/cm$^2$K) | Relative dielectric constant $\varepsilon r$ | Dielectric loss tan $\delta$ (%) | Performance index $\gamma / \varepsilon r$ |
|---|---|---|---|---|
| Example 5 | $10.5 \times 10^{-8}$ | 190 | 0.6 | $5.5 \times 10^{-10}$ |
| Comparative Example 7 | $2.5 \times 10^{-8}$ | 600 | 3.0 | $0.4 \times 10^{-10}$ |

## FIG. 10

| | Pyroelectric coefficient $\gamma$ (C/cm$^2$K) | Relative dielectric constant $\varepsilon r$ | Dielectric loss tan $\delta$ (%) | Performance index $\gamma / \varepsilon r$ |
|---|---|---|---|---|
| Example 6 | $8.5 \times 10^{-8}$ | 150 | 0.5 | $5.7 \times 10^{-10}$ |
| Comparative Example 8 | $5.0 \times 10^{-8}$ | 220 | 1.5 | $2.3 \times 10^{-10}$ |
| Comparative Example 9 | $1.2 \times 10^{-8}$ | 400 | 3.0 | $0.3 \times 10^{-10}$ |
| Comparative Example 10 | $3.5 \times 10^{-8}$ | 350 | 1.7 | $1.0 \times 10^{-10}$ |

# FIG. 11

|  | Pyroelectric coefficient $\gamma$ (C/cm²K) | Relative dielectric constant $\varepsilon$ r | Dielectric loss tan δ (%) | Performance index $\gamma / \varepsilon$ r |
|---|---|---|---|---|
| Example 7 | $9.8 \times 10^{-8}$ | 140 | 0.6 | $7.0 \times 10^{-10}$ |
| Comparative Example 11 | $0.90 \times 10^{-8}$ | 550 | 3.5 | $0.16 \times 10^{-10}$ |

# FIG. 12

|  | Pyroelectric coefficient $\gamma$ (C/cm²K) | Relative dielectric constant $\varepsilon$ r | Dielectric loss tan δ (%) | Performance index $\gamma / \varepsilon$ r |
|---|---|---|---|---|
| Example 8 | $12 \times 10^{-8}$ | 220 | 0.8 | $5.5 \times 10^{-10}$ |
| Comparative Example 12 | $2.0 \times 10^{-8}$ | 800 | 3.8 | $0.25 \times 10^{-10}$ |

# FIG. 13

|  | Pyroelectric coefficient $\gamma$ (C/cm²K) | Relative dielectric constant $\varepsilon$ r | Dielectric loss tan δ (%) | Performance index $\gamma / \varepsilon$ r |
|---|---|---|---|---|
| Example 9 | $8.0 \times 10^{-8}$ | 160 | 0.6 | $5.0 \times 10^{-10}$ |
| Comparative Example 13 | $0.70 \times 10^{-8}$ | 450 | 4.5 | $0.16 \times 10^{-10}$ |

## FIG. 14

| | Pyroelectric coefficient $\gamma$ (C/cm$^2$K) | Relative dielectric constant $\varepsilon$ r | Dielectric loss tan $\delta$ (%) | Performance index $\gamma / \varepsilon$ r | Performance index variation $\sigma$ % |
|---|---|---|---|---|---|
| Example 10 | $10.0 \times 10^{-8}$ | 800 | 0.8 | $12.5 \times 10^{-11}$ | 2.5% |
| Comparative Example 14 | $4.8 \times 10^{-8}$ | 950 | 5.5 | $5.1 \times 10^{-11}$ | 12.8% |
| Comparative Example 15 | $2.2 \times 10^{-8}$ | 1200 | 4.8 | $1.8 \times 10^{-11}$ | 8.8% |
| Comparative Example 16 | $6.0 \times 10^{-8}$ | 1050 | 3.5 | $5.7 \times 10^{-11}$ | 7.2% |

## FIG. 15

| | Pyroelectric coefficient $\gamma$ (C/cm$^2$K) | Relative dielectric constant $\varepsilon$ r | Dielectric loss tan $\delta$ (%) | Performance index $\gamma / \varepsilon$ r | Performance index variation $\sigma$ % |
|---|---|---|---|---|---|
| Example 11 | $8.5 \times 10^{-8}$ | 600 | 0.6 | $14.2 \times 10^{-11}$ | 2.2% |
| Comparative Example 17 | $1.8 \times 10^{-8}$ | 1100 | 5.2 | $1.6 \times 10^{-11}$ | 10.5% |

## FIG. 16

| | Pyroelectric coefficient $\gamma$ (C/cm$^2$K) | Relative dielectric constant $\varepsilon$ r | Dielectric loss tan $\delta$ (%) | Performance index $\gamma / \varepsilon$ r | Performance index variation $\sigma$ % |
|---|---|---|---|---|---|
| Example 12 | $12.5 \times 10^{-8}$ | 900 | 0.9 | $13.9 \times 10^{-11}$ | 3.0% |
| Comparative Example 18 | $1.2 \times 10^{-8}$ | 1800 | 12.5 | $0.67 \times 10^{-11}$ | 18.5% |

## FIG. 17

| | Pyroelectric coefficient $\gamma$ (C/cm$^2$K) | Relative dielectric constant $\varepsilon$ r | Dielectric loss tan $\delta$ (%) | Performance index $\gamma / \varepsilon$ r | Performance index variation $\sigma$ % |
|---|---|---|---|---|---|
| Example 13 | $9.5 \times 10^{-8}$ | 850 | 0.7 | $11.2 \times 10^{-11}$ | 2.8% |
| Comparative Example 19 | $2.1 \times 10^{-8}$ | 1350 | 7.2 | $1.6 \times 10^{-11}$ | 10.5% |

# EP 1 569 284 A1

## INTERNATIONAL SEARCH REPORT

| International application No. |
| --- |
| PCT/JP03/15564 |

**A. CLASSIFICATION OF SUBJECT MATTER**
Int.Cl$^7$ H01L37/02, G01J1/02, H01B3/00, H01B3/12

According to International Patent Classification (IPC) or to both national classification and IPC

**B. FIELDS SEARCHED**

Minimum documentation searched (classification system followed by classification symbols)
Int.Cl$^7$ H01L37/02, G01J1/02, H01B3/00, H01B3/12

Documentation searched other than minimum documentation to the extent that such documents are included in the fields searched
Jitsuyo Shinan Koho          1922–1996    Toroku Jitsuyo Shinan Koho    1994–2004
Kokai Jitsuyo Shinan Koho    1971–2004    Jitsuyo Shinan Toroku Koho    1996–2004

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2002-343791 A  (Sharp Corp.),<br>29 November, 2002 (29.11.02),<br>Full text; all drawings<br>(Family: none) | 1–12 |
| A | JP 2000-356546 A  (Matsushita Electric Industrial Co., Ltd.),<br>26 December, 2000 (26.12.00),<br>Full text; all drawings<br>(Family: none) | 1–12 |
| A | JP 8-172224 A  (Matsushita Electric Industrial Co., Ltd.),<br>02 July, 1996 (02.07.96),<br>Full text; all drawings<br>(Family: none) | 1–12 |

| ☒ Further documents are listed in the continuation of Box C. | ☐ See patent family annex. |
| --- | --- |

\*      Special categories of cited documents:
"A"   document defining the general state of the art which is not considered to be of particular relevance
"E"   earlier document but published on or after the international filing date
"L"   document which may throw doubts on priority claim(s) or which is cited to establish the publication date of another citation or other special reason (as specified)
"O"   document referring to an oral disclosure, use, exhibition or other means
"P"   document published prior to the international filing date but later than the priority date claimed

"T"   later document published after the international filing date or priority date and not in conflict with the application but cited to understand the principle or theory underlying the invention
"X"   document of particular relevance; the claimed invention cannot be considered novel or cannot be considered to involve an inventive step when the document is taken alone
"Y"   document of particular relevance; the claimed invention cannot be considered to involve an inventive step when the document is combined with one or more other such documents, such combination being obvious to a person skilled in the art
"&"   document member of the same patent family

| Date of the actual completion of the international search<br>    16 February, 2004 (16.02.04) | Date of mailing of the international search report<br>    02 March, 2004 (02.03.04) |
| --- | --- |
| Name and mailing address of the ISA/<br>    Japanese Patent Office | Authorized officer |
| Facsimile No. | Telephone No. |

Form PCT/ISA/210 (second sheet) (July 1998)

## INTERNATIONAL SEARCH REPORT

| International application No. |
| --- |
| PCT/JP03/15564 |

| C (Continuation). DOCUMENTS CONSIDERED TO BE RELEVANT | | |
| --- | --- | --- |
| Category* | Citation of document, with indication, where appropriate, of the relevant passages | Relevant to claim No. |
| A | JP 8-139307 A (Toyota Central Research And Development Laboratories, Inc.), 31 May, 1996 (31.05.96), Full text; all drawings (Family: none) | 1-12 |
| A | JP 8-133738 A (Ube Industries, Ltd.), 28 May, 1996 (28.05.96), Full text; all drawings (Family: none) | 1-12 |

Form PCT/ISA/210 (continuation of second sheet) (July 1998)